(19) **Europäisches Patentamt / European Patent Office / Office européen des brevets**

(11) **EP 1 010 205 B1**

(12) **EUROPÄISCHE PATENTSCHRIFT**

(45) Veröffentlichungstag und Bekanntmachung des Hinweises auf die Patenterteilung:
**07.02.2007 Patentblatt 2007/06**

(51) Int Cl.:
***H01L 29/76*** *(2006.01)*

(21) Anmeldenummer: **98952513.4**

(22) Anmeldetag: **26.08.1998**

(86) Internationale Anmeldenummer:
**PCT/DE1998/002521**

(87) Internationale Veröffentlichungsnummer:
**WO 1999/012212 (11.03.1999 Gazette 1999/10)**

(54) **SCHALTUNGSANORDNUNG MIT EINZELELEKTRON-BAUELEMENTEN, VERFAHREN ZU DEREN BETRIEB UND ANWENDUNG DES VERFAHRENS ZUR ADDITION VON BINÄRZAHLEN**

LONE-ELECTRON CIRCUIT ARRANGEMENT, OPERATING MODE, AND APPLICATION FOR ADDING BINARY NUMBERS

CONFIGURATION DE CIRCUIT A COMPOSANTS UNI-ELECTRONIQUES, LEUR MODE DE FONCTIONNEMENT, ET APPLICATION POUR L'ADDITION DE NOMBRES BINAIRES

(84) Benannte Vertragsstaaten:
**DE FR GB IT**

(30) Priorität: **01.09.1997 DE 19738115**

(43) Veröffentlichungstag der Anmeldung:
**21.06.2000 Patentblatt 2000/25**

(73) Patentinhaber: **Infineon Technologies AG
81669 München (DE)**

(72) Erfinder:
 • **RÖSNER, Wolfgang
  D-81739 München (DE)**
 • **RAMCKE, Ties
  D-81739 München (DE)**
 • **RISCH, Lothar
  D-85579 Neubiberg (DE)**

(74) Vertreter: **Jannig, Peter et al
Jannig & Repkow,
Patentanwälte,
Klausenberg 20
86199 Augsburg (DE)**

(56) Entgegenhaltungen:
 • **BENJAMIN S C ET AL: "A possible nanometer-scale computing device based on an adding cellular automaton" APPLIED PHYSICS LETTERS, 28 APRIL 1997, AIP, USA, Bd. 70, Nr. 17, Seiten 2321-2323, XP002098350 ISSN 0003-6951 in der Anmeldung erwähnt**
 • **T. MOK ET AL.: "A CHARGE-TRANSFER-DEVICE LOGIC CELL" SOLID STATE ELECTRONICS., Bd. 17, Nr. 11, November 1974, Seiten 1147-1154, XP002098351 OXFORD GB**
 • **NOMOTO T ET AL: "Single electron-photon logic device using coupled quantum dots: computation with the Fock ground state" JOURNAL OF APPLIED PHYSICS, 1 JAN. 1996, AIP, USA, Bd. 79, Nr. 1, Seiten 291-300, XP002098352 ISSN 0021-8979**
 • **IWAMURA H ET AL: "SINGLE-ELECTRON MAJORITY LOGIC CIRCUITS" IEICE TRANSACTIONS ON ELECTRONICS, Bd. E81-C, Nr. 1, Januar 1998, Seiten 42-48, XP000767487**
 • **TUCKER J.R.: J. APPL. PHYS., Bd. 72, Nr. 9, 1. November 1992 (1992-11-01), Seiten 4399-4413, XP000315847 NY**
 • **ROSNER: MICROELECTRONICS ENGINEERING, Bd. 27, 1995, Seiten 55-58,**

**EP 1 010 205 B1**

**Beschreibung**

Die Erfindung bezieht sich auf eine Schaltungsanordnung mit Einzelelektron-Bauelementen, die unter anderem als Logikschaltung geeignet ist.

Integrierte Schaltungsanordnungen für Logikanwendungen werden derzeit hauptsächlich in CMOS-Technologie realisiert. Bei fortschreitender Bauelemente-Verkleinerung wird diese herkömmliche CMOS-Technologie an ihre Grenzen stoßen.

Im Hinblick auf eine weitere Miniaturisierung sind sogenannte Einzelelektron-Bauelemente vorgeschlagen worden, in denen Schaltvorgänge mit einzelnen Elektronen realisiert werden. Eine Untersuchung über derartige Einzelelektron-Bauelemente ist zum Beispiel aus W. Rösner et al, Microelectronic Engineering, Bd. 27, 1995, Seiten 55 bis 58, bekannt. Einzelelektron-Bauelemente umfassen Tunnelelemente, die über Tunnelkontakte mit benachbarten Anschlüssen verbunden sind. Ladungsübertritte über diese Tunnelkontakte erfolgen sowohl über den quantenmechanischen Tunneleffekt als auch durch einfache thermische Überwindung einer Potentialbarriere, wobei diese Ladungsübertritte hinreichend selten auftreten. Die Tunnelelemente sind zum Beispiel als kleine leitfähige Inseln realisiert, die von einer isolierenden Struktur umgeben sind. Wird an die beiden Anschlüsse eine Spannung U angelegt, für die die Bedingung für Coulomb-Blockade erfüllt ist, das heißt für deren Betrag

$$|U| \; < \; e \, / \, (2C)$$

gilt, so kann sich die Ladung des Tunnelelementes aufgrund der Potentialverhältnisse nicht verändern, sofern für die thermische Energie

$$\frac{kT}{e} \; \ll \; \frac{e}{2C} \cdot$$

gilt.

Dabei ist k die Stefan Boltzmann Konstante, T die Temperatur, e die Elektronenladung, C die Kapazität des Tunnelelementes.

Bei Anlegen einer höheren Spannung können Elektronen über einen der Tunnelkontakte auf das Tunnelelement fließen. Diese Einzelelektron-Bauelemente werden so betrieben, daß jeweils ein Übertritt einzelner Elektronen erfolgt.

Durch Ansteuerung des Tunnelelementes über eine Gateelektrode, die das Tunnelelement kapazitiv beeinflußt, ohne daß es im Betriebsspannungsbereich zu Tunnelübergängen käme, ist es möglich, die Coulomb-Blockade aufzuheben. Sofern an der Gateelektrode eine geeignete elektrische Ladung wirksam ist, weist das Einzelelektron-Bauelement eine in etwa lineare, durch den Nullpunkt gehende Stromspannungskennlinie auf. Ein derartiges gategesteuertes Einzelelektron-Bauelement wird in der Literatur als Einzelelektron-Transistor bezeichnet.

Eine weitere Schaltungsanordnung ist in dem Dokument J. Appl. Phys 72, 9, 1.11.92, S.4399-4413 beschriebe. Der Erfindung liegt das Problem zugrunde, eine Schaltungsanordnung mit Einzelelektron-Bauelementen anzugeben, die unter anderem als Logikschaltung geeignet ist. Darüber hinaus soll ein Betriebsverfahren für eine derartige Schaltungsanordnung angegeben werden.

Dieses Problem wird erfindungsgemäß gelöst durch eine Schaltungsanordnung nach Anspruch 1 sowie durch ein Verfahren zu deren Betrieb nach Anspruch 8. Weitere Ausgestaltungen der Erfindung gehen aus den Unteransprüchen hervor.

Die Schaltungsanordnung weist mindestens einen ersten Einzelelektrontransistor auf, der zwischen einen ersten Hauptknoten und einen zweiten Hauptknoten geschaltet ist. Der erste Hauptknoten ist kapazitiv zwischen einen ersten Betriebsspannungsanschluß und einen zweiten Betriebsspannungsanschluß geschaltet. Die Gateelektrode des ersten Einzelelektrontransistors ist mit einem Steuerspannungsanschluß verbunden. Der Einzelelektrontransistor weist ein Tunnelelement auf, das über zwei Tunnelkontakte mit Anschlüssen verbunden ist und das über eine Gateelektrode kapazitiv beeinflußbar ist. Da die Höhe der Potentialbarriere zwischen dem Tunnelelement und dem jeweiligen Anschluß abhängig von der an diesem Anschluß wirksamen Ladungsmenge ist, lassen sich mit Hilfe des ersten Einzelelektrontransistors logische Verknüpfungen realisieren. Dazu werden Ladungsträger, die dem logischen Wert zugeordnet werden, auf den ersten Hauptknoten und den zweiten Hauptknoten aufgebracht. Zum Beispiel wird dem logischen Wert Eins ein Elektron und dem logischen Wert Null kein Elektron zugeordnet.

Befindet sich nun auf dem ersten Hauptknoten kein Elektron (logisch Null) und auf dem zweiten Hauptknoten ein Elektron (logisch Eins) und wird die Gateelektrode des ersten Einzelelektrontransistors angesteuert, so daß ein Stromfluß von dem zweiten Hauptknoten zu dem ersten Hauptknoten über das Tunnelelement möglich ist, so fließt das Elektron vom zweiten Hauptknoten auf den ersten Hauptknoten. Befindet sich dagegen auf dem ersten Hauptknoten ebenfalls ein Elektron (logisch Eins), so kann das Elektron vom zweiten Hauptknoten nicht auf den ersten Hauptknoten fließen. Befindet sich auf dem zweiten Hauptknoten kein Elektron (logisch Null) und auf dem ersten Hauptknoten ein Elektron (logisch Eins), so bleibt bei der entsprechenden Ansteuerung das Elektron auf dem ersten Hauptknoten erhalten (logische Eins). Befindet sich auf dem zweiten Hauptknoten kein Elektron (logische Null) und auf dem ersten Hauptknoten kein Elektron (logische Null), so befindet sich auch nach Ansteuerung des ersten Einzelelektrontransistors kein Elektron auf dem ersten Hauptknoten (logische Null). Die Ladung am ersten Hauptknoten nach der Verknüpfung zeigt daher das Ergebnis einer ODER-Verknüpfung der Ausgangsbits am ersten Hauptknoten und zweiten Hauptknoten.

Die Verbindung zwischen dem ersten Hauptknoten und dem ersten Betriebsspannungsanschluß bzw. dem zweiten Betriebsspannungsanschluß erfolgt zum Beispiel über einen Kondensator.

Es liegt im Rahmen der Erfindung, zwischen dem ersten Hauptknoten und dem zweiten Betriebsspannungsanschluß einen zweiten Einzelelektrontransistor zu schalten, dessen Gateelektrode mit dem zweiten Hauptknoten verbunden ist. Über den zweiten Einzelelektron-Transistor läßt sich die Ladung am ersten Hauptknoten verändern. Dieses ist zum Beispiel für einen Reset der Schaltungsanordnung einsetzbar. Diese Ausführungsform der Schaltungsanordnung erlaubt darüberhinaus komplexere logische Verknüpfungen, da nun die Ansteuerung des zweiten Einzelelektrontransistors davon abhängig ist, welche Ladung am zweiten Hauptknoten wirksam ist. Über den zweiten Einzelelektrontransistor ist die am ersten Hauptknoten befindliche Ladung in Abhängigkeit der am zweiten Hauptknoten befindliche Ladung veränderbar.

Die Schaltungsanordnung weist gemäß einer Ausführungsform mindestens einen ersten Schaltungszweig und einen zweiten Schaltungszweig auf. Der erste Schaltungszweig und der zweite Schaltungszweig weisen dabei jeweils einen ersten Einzelelektron-Transistor und einen zweiten Einzelelektron-Transistor auf, die über einen ersten Hauptknoten miteinander in Reihe verschaltet sind. Der erste Einzelelektron-Transistor und der zweite Einzelelektron-Transistor umfassen dabei jeweils ein Tunnelelement, das über zwei Tunnelkontakte mit Anschlüssen verbunden ist und das über eine Gateelektrode kapazitiv ansteuerbar ist. Über die Tunnelkontakte erfolgen Ladungsübertritte sowohl durch quantenmechanischen Tunneleffekt als auch durch hinreichend seltene thermische Überwindung einer Potentialbarriere. Ist der Tunnelwiderstand der Tunnelkontakte

$$R_T > R_k = h / e^2 \approx 26K\Omega$$

wobei $R_K$ der Klitzing-Widerstand, h das Planck'sche Wirkungsquantum und e eine Elektronenladung ist, so sind die Ladungsträger auf einer der Seiten der Potentialbarriere lokalisiert und es erfolgt die Mehrzahl der Ladungsübertritte durch Elementarprozesse. Vorzugsweise ist der Tunnelwiderstand > 100 kΩ.

Der erste Hauptknoten, in dem jeweils ein Anschluß des ersten Einzelelektron-Transistors mit einem Anschluß des zweiten Einzelelektron-Transistors verbunden ist, ist über einen Kondensator mit einem ersten Betriebsspannungsanschluß verbunden. Die Reihenschaltung aus dem ersten Einzelelektron-Transistor und dem zweiten Einzelelektron-Transistor ist zwischen einen zweiten Hauptknoten und einem zweiten Betriebsspannungsanschluß geschaltet. Die Gateelektrode des ersten Einzelelektron-Transistors ist mit einem Steuerspannungsanschluß verbunden. Die Gateelektrode des zweiten Einzelelektron-Transistors ist mit dem zweiten Hauptknoten verbunden. Der erste Hauptknoten des zweiten Schaltungszweigs ist mit dem zweiten Hauptknoten des ersten Schaltungszweigs verbunden. Somit sind die miteinander verbundenen Anschlüsse des ersten Einzelelektron-Transistors und des zweiten Einzelelektron-Transistors des zweiten Schaltungszweiges mit der Gateelektrode des zweiten Einzelelektron-Transistor des ersten Schaltungszweigs verbunden.

Zur Realisierung eineer zyklischen Anordnung ist der zweite Hauptknoten des zweiten Schaltungszweigs mit dem ersten Hauptknoten des ersten Schaltungszweigs verbunden. Dadurch ist die Gateelektrode des zweiten Einzelelektron-Transistors des zweiten Schaltungszweigs mit den miteinander verbundenen Anschlüssen des ersten Einzelelektron-Transistors und des zweiten Einzelelektron-Transistors des ersten Schaltungszweigs verbunden.

Abhängig von der Ansteuerung der ersten Einzelelektron-Transistoren und der Spannung am ersten Betriebsspannungsanschluß können in dieser Schaltungsanordnung im ersten Schaltungszweig und im zweiten Schaltungszweig Elektronen auf den ersten Hauptknoten und/oder den zweiten Hauptknoten aufgebracht werden. Darüber hinaus können abhängig von der Ansteuerung des ersten Einzelelektron-Transistors Elektronen vom ersten Hauptknoten auf den zweiten Hauptknoten bzw. vom zweiten Hauptknoten auf den ersten Hauptknoten oder von einem der Hauptknoten auf den Tunnelübergang des ersten Einzelelektron-Transistors fließen. Dabei wird ausgenutzt, daß die Höhe der Potentialbarriere zwischen dem Tunnelelement und dem benachbarten Hauptknoten unter anderem von der am Hauptknoten wirksamen Ladungsmenge abhängt. Je nach Ansteuerung des zweiten Einzelelektron-Transistors können Elektronen vom ersten Hauptknoten zum zweiten Betriebsspannungsanschluß abfließen. Die Ansteuerung des zweiten Einzelelektron-Transistors erfolgt über die an der Gateelektrode anliegende Spannung, die einerseits durch die auf dem zweiten Hauptknoten befindliche Ladung und andererseits durch die am ersten Betriebsspannungsanschluß des benachbarten Schaltungszweigs anliegende Spannung bestimmt wird. Das heißt, der zweite Einzelelektron-Transistor kann in Abhängigkeit der auf dem zweiten Hauptknoten gespeicherten Ladung geschaltet werden. Somit ist die Schaltungsanordnung dazu geeignet, logische Verknüpfungen entsprechend einer vorgegebenen Verknüpfungstabelle auszuführen. Die Schaltungsanordnung ist dabei insbesondere als Prozessor, als Addierer, Multiplizierer oder logisches Gatter geeignet.

Zur Durchführung einer logischen Verknüpfung zwischen zwei mehrstelligen digitalen Informationen, zum Beispiel zwei Binärzahlen, liegt es im Rahmen der Erfindung, daß die Schaltungsanordnung mehrere Schaltungsblöcke aufweist. Jeder der Schaltungsblöcke enthält einen ersten Schaltungszweig und einen zweiten Schaltungszweig. Dabei weisen der erste Schaltungszweig und der zweite Schaltungszweig jeweils einen ersten Einzelelektron-Transistor und einen zweiten Einzelelektron-Transistor auf, die über einen ersten Hauptknoten miteinander in Reihe verschaltet sind. Der erste Hauptknoten ist über einen Kondensator mit einem ersten Betriebsspannungsanschluß verbunden. Die in Reihe verschalteten ersten und zweiten Einzelelektron-Transistoren sind zwischen einen zweiten Hauptknoten und einen zweiten Betriebsspannungsanschluß geschaltet. Die Gateelektrode des ersten Einzelelektron-Transistors ist mit einem Steuerspannungsanschluß verbunden. Die Gateelektrode des zweiten Einzelelektron-Transistors ist mit dem zweiten Hauptknoten verbunden. Der zweite Hauptknoten des zweiten Schaltungszweigs eines der Schaltungsblöcke ist dabei jeweils mit dem ersten Hauptknoten des ersten Schaltungszweigs des benachbarten Schaltungsblocks verbunden. Der zweite Hauptknoten des zweiten Schaltungszweigs des letzten Schaltungsblocks ist mit dem ersten Hauptknoten des ersten Schaltungsblocks verbunden. Sind n-Schaltungsblöcke vorgesehen, so ist der zweite Hauptknoten des zweiten Schaltungszweigs des i-ten Schaltungsblocks mit i = 1, ... n - 1 jeweils mit dem ersten Hauptknoten des ersten Schaltungszweigs des i + 1-ten Schaltungsblocks verbunden. Der zweite Hauptknoten des zweiten Schaltungszweigs des n-ten Schaltungsblocks ist mit dem ersten Hauptknoten des ersten Schaltungszweigs des ersten Schaltungsblocks verbunden.

Weist die zu verarbeitende Information n Stellen auf und kommt die angewendete logische Verknüpfung ohne Übertrag oder Vorzeichen aus, so werden n Schaltungsblöcke benötigt. Weist die logische Information n Stellen auf und werden für die logische Verknüpfung ein Übertrag oder ein Vorzeichen benötigt, so sind für die Schaltungsanordnung n + 1 Schaltungsblöcke erforderlich. Dieses ist zum Beispiel bei der Anwendung der Schaltungsanordnung als Addierer der Fall.

Wird die Schaltungsanordnung mit mehreren Schaltungsblöcken so betrieben, daß Ladungsträger nur auf die ersten Hauptknoten der ersten Schaltungszweige oder nur auf die ersten Hauptknoten der zweiten Schaltungszweige aufgebracht werden, so ist die Schaltungsanordnung als Schieberegister geeignet.

Vorzugsweise weisen der Kondensator, der erste Einzelelektron-Transistor und der zweite Einzelelektron-Transistor im ersten Schaltungszweig und im zweiten Schaltungszweig sowie gegebenenfalls in allen Schaltungsblöcken im wesentlichen die gleiche elektrische Dimensionierung auf. Dadurch vereinfacht sich die Herstellung der Schaltungsanordnung und die Ansteuerung der Schaltungsanordnung erheblich.

Darüber hinaus ist es in bezug auf die vereinfachte Ansteuerung vorteilhaft, wenn der erste Einzelelektron-Transistor jeweils zwei Tunnelkontakte mit im wesentlichen gleicher Kapazität und der zweite Einzelelektron-Transistor zwei Tunnelkontakte mit unterschiedlicher Kapazität aufweist.

Ebenfalls in bezug auf die Ansteuerung ist es vorteilhaft, den zweiten Betriebsspannungsanschluß im ersten Schaltungszweig mit dem zweiten Betriebsspannungsanschluß im zweiten Schaltungszweig sowie gegebenenfalls in allen Schaltungsblökken zu verbinden. Im Betrieb wird der zweite Betriebsspannungsanschluß vorzugsweise mit dem geringeren von zwei Betriebsspannungspegeln, zum Beispiel Erde, verbunden.

Zum Betrieb der Schaltungsanordnung wird an den ersten Betriebsspannungsanschluß des ersten Schaltungszweiges jeweils ein erster Spannungspegel, an den Steueranschluß des ersten Schaltungszweigs jeweils ein zweiter Spannungspegel, an den ersten Betriebsspannungsanschluß des zweiten Schaltungszweiges jeweils ein dritter Spannungspegel und an den Steueranschluß des zweiten Schaltungszweiges jeweils ein vierter Spannungspegel angelegt. Entsprechend zu verknüpfender Ausgangsbits werden der erste Hauptknoten und der zweite Hauptknoten des ersten Schaltungszweiges mit Ladungsträgern beaufschlagt. Für den logischen Wert Eins wird zum Beispiel ein Elektron und für den logischen Wert Null kein Elektron aufgebracht. Die Schaltungsanordnung wird zum Beispiel mit Spannungsverläufen, die jeweils drei Schritte aufweisen, betrieben.

Dabei werden in einem ersten Schritt die Werte für den ersten Spannungspegel, den zweiten Spannungspegel, den dritten Spannungspegel und den vierten Spannungspegel so eingestellt, daß auf dem zweiten Hauptknoten des ersten Schaltungszweigs befindliche Ladungsträger auf den ersten Hauptknoten des ersten Schaltungszweiges fließen, sofern sich auf diesem ersten Hauptknoten zuvor kein Ladungsträger befand. Befindet sich auf dem ersten Hauptknoten zuvor ein Ladungsträger, so fließen auf dem zweiten Hauptknoten des ersten Schaltungszweiges befindliche Ladungsträger auf den Tunnelübergang des ersten Einzelelektron-Transistors des ersten Schaltungszweiges.

In einem zweiten Schritt werden die Werte für den ersten Spannungspegel, den zweiten Spannungspegel, den dritten Spannungspegel und den vierten Spannungspegel so eingestellt, daß auf dem Tunnelübergang des ersten Einzelelektron-Transistors des ersten Schaltungszweiges befindliche Ladungsträger auf den zweiten Hauptknoten des ersten Schaltungszweiges fließen. Bedingt durch die Ansteuerung im ersten Schritt sind die zweiten Hauptknoten des ersten Schaltungszweiges jeweils abgeräumt. Im zweiten Schritt werden daher nur die zweiten Hauptknoten derjenigen ersten Schaltzweige mit Ladungsträgern beaufschlagt, in denen bereits vor dem ersten Schritt der erste und der zweite Hauptknoten mit je einem Ladungsträger beaufschlagt war.

In einem dritten Schritt werden die Werte für den ersten Spannungspegel, den zweiten Spannungspegel, den dritten Spannungspegel und den vierten Spannungspegel so eingestellt, daß auf dem ersten Hauptknoten des ersten Schaltungszweigs befindliche Ladungsträger über den zweiten Einzelelektron-Transistor des jeweiligen ersten Schaltungszweiges zum zweiten Betriebsspannungsanschluß fließen, sofern sich auf dem zweiten Hauptknoten des jeweiligen ersten Schaltungszweiges ein Ladungsträger befindet. In diesem Schritt wird ausgenutzt, daß bei der Ansteuerung des zweiten Einzelelektron-Transistors sowohl der an dem ersten Betriebsspannungsanschluß des zweiten Schaltungszweiges anliegende dritte Spannungspegel als auch die auf dem zweiten Hauptknoten des ersten Schaltungszweiges anwesende Ladungsmenge wirksam sind.

Nach Durchführung dieser drei Schritte ergibt sich für die auf dem ersten Hauptknoten und dem zweiten Hauptknoten des ersten Schaltungszweiges gespeicherte Ladung folgende Verknüpfung:

| Information am 1. Hauptknoten | | |
|---|---|---|
| Information am 2. Hauptknoten | 0 | 1 |
| 0 | 00 | 01 |
| 1 | 01 | 10 |

In dem ersten Hauptknoten liegt damit eine XOR-Verknüpfung der Ausgangsbits und im zweiten Hauptknoten eine AND-Verknüpfung der Ausgangsbits vor.

Werden nur der erste und der zweite Schritt des Spannungsverlaufs durchgeführt, so ergibt sich für die auf dem ersten Hauptknoten und dem zweiten Hauptknoten des ersten Schaltungszweigs gespeicherte Ladung folgende Verknüpfung:

| Information am 1. Hauptknoten | | |
|---|---|---|
| Information am 2. Hauptknoten | 0 | 1 |
| 0 | 00 | 01 |
| 1 | 01 | 11 |

Im ersten Hauptknoten liegt damit eine OR-Verknüpfung und in dem zweiten Hauptknoten eine AND-Verknüpfung der Ausgangsbits vor.

Soll die Schaltungsanordnung nur mit den zwei Schritten des Spannungsverlaufs betrieben werden so kann in einer nicht beanspruchten Ausführungsform, der zweite Einzelelektron-Transistor auch durch einen Kondensator ersetzt werden.

Mit der Schaltungsanordnung lassen sich logische Verknüpfungen entsprechend dieser Verknüpfungstabellen durchführen. Weitere Verknüpfungsmöglichkeiten sind nicht ausgeschlossen.

Zur Verknüpfung von zwei mehrstelligen digitalen Informationen werden jeweils die entsprechenden Stellen in den ersten Hauptknoten und den zweiten Hauptknoten des ersten Schaltungszweiges des jeweiligen Schaltungsblocks eingeschrieben. Anschließend wird ein erster Durchlauf mit dem Spannungsverlauf entsprechend den beschriebenen drei Schritten durchgeführt. Nachfolgend wird ein zweiter Durchlauf durchgeführt, bei dem der erste Spannungspegel und der zweite Spannungspegel jeweils an den ersten Betriebsspannungsanschluß und den Steuerspannungsanschluß des zweiten Schaltungszweiges und der dritte Spannungspegel und der vierte Spannungspegel jeweils an den ersten Betriebsspannungsanschluß und den Steuerspannungsanschluß des ersten Schaltungzweiges angelegt werden. Nachfolgend werden der erste bis der dritte Schritt durchgeführt, wobei die Werte für die ersten, zweiten, dritten und vierten Spannungspegel wie beim ersten Durchlauf durchlaufen werden. Bei dem zweiten Durchlauf werden Einflüsse, die benachbarte Stellen der digitalen Information bei der Verknüpfung aufeinander haben, zum Beispiel Überträge, verarbeitet.

Bei logischen Verknüpfungen, bei denen es zu Überträgen kommt, werden in den ersten Hauptknoten und den zweiten Hauptknoten des ersten Schaltungszweiges des höchsten Schaltungsblocks anfangs jeweils eine Null eingeschrieben. Diese Stellen stehen nachfolgend für die Erhöhung der Stellenzahl des Ergebnisses infolge des Übertrags zur Verfügung.

Die Dauer der einzelnen Schritte und damit der Takt werden so bemessen, daß die Ladungsübertritte sicher stattfinden. Die Dauer der einzelnen Schritte liegt insbesondere zwischen 1 ps und 1 ms.

Die Schaltungsanordnung ist insbesondere geeignet zur Durchführung einer Addition von Binärzahlen nach einem Algorithmus, der zum Beispiel aus S. C. Benjamin et al, Appl. Phys. Lett., Bd. 70 (17), April 1997, Seiten 2321 bis 2323, bekannt ist. Der Algorithmus wird in dieser Veröffentlichung auf einem zellulären Automaten realisiert, der auf der Basis von Quantenpunkten aufgebaut ist. Die Information wird dabei durch optische Anregung, zum Beispiel mit einem Laser, eingeschrieben. Zwischen den einzelnen Quantenpunkten sind keine Tunnelübergänge erlaubt.

In diesem Additionsalgorithmus werden entsprechende Stellen der zu addierenden Binärzahlen addiert. Dabei wird eine Summe und ein Übertrag ermittelt. Bei der Addition zweier mehrstelliger Binärzahlen erfolgt diese Addition stufenweise. Das heißt, es wird Stelle für Stelle zunächst Summe und Übertrag bestimmt. Nachfolgend wird der Übertrag mit der Summe der nächsthöheren Stelle addiert, wobei wiederum eine Summe und ein Übertrag entsteht. Das Verfahren wird bei n-stelligen Binärzahlen n + 1 mal durchgeführt.

In der erfindungsgemäßen Schaltungsanordnung werden zur Addition zweier n-stelliger Binärzahlen nach diesem Algorithmus n + 1 Schaltungsblöcke benötigt. Die entsprechenden Stellen der zu addierenden Binärzahlen werden jeweils in dem ersten Hauptknoten und dem zweiten Hauptknoten des entsprechenden ersten Schaltungszweiges eingeschrieben. Nach dem ersten Durchlauf mit drei Schritten enthält der erste Hauptknoten des ersten Schaltungszweiges die Summe und der zweite Hauptknoten des ersten Schaltungszweiges den Übertrag. Beim zweiten Durchlauf wird nunmehr die Summe aus dem Übertrag und der Summe der nächsthöheren Stelle gebildet. Dabei wird ausgenutzt, daß der zweite Hauptknoten des ersten Schaltungszweiges jeweils mit dem ersten Hauptknoten des zweiten Schaltungszweiges und der zweite Hauptknoten des zweiten Schaltungszweiges mit dem ersten Hauptknoten des ersten Schaltungszweiges im nächsten Schaltungsblock verbunden ist. Der erste Durchlauf und der zweite Durchlauf des Verfahrens werden nachfolgend alternierend durchgeführt bis insgesamt n + 1 Durchläufe ausgeführt sind. Für ungerade n enthält danach der erste Hauptknoten der ersten Schaltungszweige jeweils eine Null, während der zweite Hauptknoten der ersten Schaltungszweige jeweils die Werte der einzelnen Stellen der Summe enthält. Bedingt durch die alternierende Durchführung der ersten und zweiten Durchläufe sind dabei die Stellen der Binärzahl insgesamt um (n + 1)/2 Schaltungsblöcke verschoben. Im Fall geradzahliger n enthält danach der erste Hauptknoten der ersten Schaltungszweige jeweils den Wert der betreffenden Stelle der Summe und der zweite Hauptknoten der ersten Schaltungszweige jeweils eine Null. Die Stellen der Binärzahlen sind um n/2 Schaltungsblöcke verschoben.

Als Tunnelelemente kommen alle Strukturen in Betracht, die einen elektrisch leitfähigen Bereich umfassen und die über eine Isolationsstruktur gegenüber benachbarten elektrisch leitfähigen Bereichen isoliert sind. Über die Isolationsstruktur sind die elektrisch leitfähigen Bereiche durch Tunnelkontakte verbunden. Als Tunnelelemente sind insbesondere Strukturen geeignet, die einen leitfähigen Kern und eine den leitfähigen Kern umgebende isolierende Hülle umfassen. Der Durchmesser des Tunnelelements liegt dabei vorzugsweise zwischen 1 und 10 nm. Die Kapazität der Tunnelelemente ist in diesem Größenbereich so klein, daß die Schaltungsanordnung im Raumtemperaturbereich funktioniert. Insbesondere sind als Tunnelelemente Metallcluster mit organischen Liganden als isolierender Hülle, wie sie aus DE 42 12 220 A1 bekannt sind, oder Fullerene mit eingeschlossenem Metallkern geeignet.

Desweiteren sind als Tunnelelemente lithographisch strukturierte dünne Metallschichten geeignet, wobei die Tunnelkontakte durch Oxidation einer solchen Metallschicht und nachfolgende Abscheidung und Strukturierung einer weiteren Metallschicht entstehen. Ferner sind als Tunnelelemente δ-dotierte III-V-Halbleiter geeignet. Im Rahmen einer molekularen Elektronik sind als Tunnelelemente auch Abschnitte einzelner Moleküle geeignet, die abhängig von ihrer Vorgeschichte unterschiedliche Ladungen tragen können. Der Ladungsübertritt zwischen solchen umladbaren Molekülabschnitten erfolgt entlang chemischer Bindungen.

Im folgenden wird die Erfindung anhand von Ausführungsbeispielen, die in den Figuren dargestellt sind, näher erläutert.

Figur 1          zeigt eine Schaltungsanordnung mit einem ersten Schaltungszweig und einem zweiten Schaltungszweig.

Figur 2         zeigt eine Schaltungsanordnung mit vier Schaltungsblöcken, die zur Addition von zwei dreistelligen Binärzahlen geeignet ist.

Figur 3a bis 3l     zeigt die Schritte, die zur Addition von zwei dreistelligen Binärzahlen erforderlich sind.

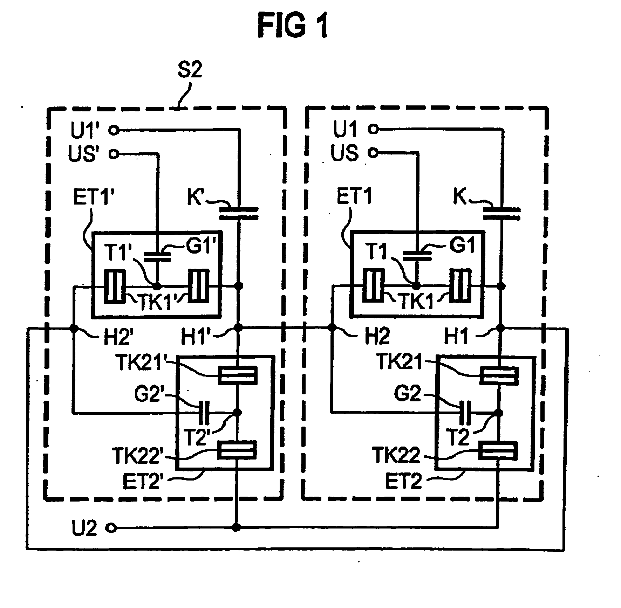

Eine Schaltungsanordnung weist einen ersten Schaltungszweig S1 und einen zweiten Schaltungszweig S2 auf (siehe Figur 1). In dem ersten Schaltungszweig S1 sind ein erster Einzelelektron-Transistor ET1 und ein zweiter Einzelelektron-Transistor ET2 sowie ein Kondensator K mit einer Kapazität von 0,8 aF vorgesehen. Der erste Einzelelektron-Transistor ET1 enthält ein Tunnelelement T1, das zwischen zwei Tunnelkontakten TK1 angeordnet ist und das über eine Gateelektrode G1 kapazitiv ansteuerbar ist. Die Gateelektrode G1 weist eine Kapazität von zum Beispiel 0,4 aF und die Tunnelkontakte TK1 eine Kapazität von jeweils 0,25 aF auf.

Der zweite Einzelelektron-Transistor ET2 weist ein Tunnelelement T2 auf, das zwischen einem ersten Tunnelkontakt TK21 und einem zweiten Tunnelkontakt TK22 angeordnet ist und das kapazitiv über eine Gateelektrode G2 ansteuerbar ist. Die Gateelektrode G2 weist eine Kapazität von zum Beispiel 0,2 aF auf. Der erste Tunnelkontakte TK21 weist eine Kapazität von 0,4 aF und der zweite Tunnelkontakt TK22 eine Kapazität von 0,1 aF auf.

Der erste Einzelelektron-Transistor ET1 und der zweite Einzelelektron-Transistor ET2 sind in Reihe verschaltet. Dabei sind einer der Tunnelkontakte TK1 des ersten Einzelelektron-Transistors ET1 und der erste Tunnelkontakt TK21 des zweiten Einzelelektron-Transistors ET2 in einem ersten Hauptknoten H1 miteinander verbunden. Der erste Hauptknoten H1 ist über den Kondensator K mit einem ersten Betriebsspannungsanschluß U1 verbunden.

Die Reihenschaltung aus dem ersten Einzelelektron-Transistor ET1 und dem zweiten Einzelelektron-Transistor ET2 ist zwischen einem zweiten Hauptknoten H2 und einem zweiten Betriebsspannungsanschluß U2 geschaltet. Die Gateelektrode G1 des ersten Einzelelektron-Transistors ist mit einem Steuerspannungsanschluß US verbunden.

Der zweite Schaltungszweig S2 ist analog zum ersten Schaltungszweig S1 aufgebaut. Er weist einen ersten Einzelelektron-Transistor ET1' auf, der mit einem zweiten Einzelelektron-Transistor ET2' in Reihe verschaltet ist. Der erste Einzelelektron-Transistor ET1' weist ein Tunnelelement T1' zwischen zwei Tunnelkontakten TK1' und eine Gateelektrode G1' auf, die entsprechend dem ersten Einzelelektron-Transistor ET1 des ersten Schaltungszweiges S1 dimensioniert sind. Der zweite Einzelelektron-Transistor ET2' ist analog dem zweiten Einzelelektron-Transistor ET2 des ersten Schaltungszweiges S1 mit einer Gateelektrode G2', einem Tunnelelement T2', einem ersten Tunnelkontakt T21' und einem zweiten Tunnelkontakt TK22' mit analoger Dimensionierung versehen. Der erste Einzelelektron-Transistor ET1' und der zweite Einzelelektron-Transistor ET2' sind über einen ersten Hauptknoten H1' miteinander verbunden. Der erste Hauptknoten H1' ist über einen Kondensator K' mit einer Kapazität von 0,8 aF mit einem ersten Betriebsspannungsanschluß U1' verbunden. Die in Reihe verschalteten Einzelelektron-Transistoren ET1', ET2' sind zwischen dem zweiten Hauptknoten H2' und dem zweiten Betriebsspannungsanschluß U2 verschaltet. Die Gateelektrode G1' des ersten Einzelelektron-Transistors ET1' ist mit einem Steuerspannungsanschluß US' verbunden. Die Gateelektrode G2' des zweiten Einzelelektron-Transistors ET2' ist mit dem zweiten Hauptknoten H2' verbunden.

Der zweite Hauptknoten H2 des ersten Schaltungszweiges S1 ist mit dem ersten Hauptknoten H1' des zweiten Schaltungskreises S2 verbunden. Der erste Hauptknoten H1 des ersten Schaltungszweiges S1 ist mit dem zweiten Hauptknoten H2' des zweiten Schaltungskreises S2 verbunden. Somit ist bei der Ansteuerung des zweiten Einzelelektron-Transistors ET2 des ersten Schaltungszweiges sowohl auf dem zweiten Hauptknoten H2 des ersten Schaltungszweigs S1 gespeicherte Ladung als auch der am ersten Betriebsspannungsanschluß U1' des zweiten Schaltungszweiges S2 anliegende Spannungspegel wirksam. Entsprechend ist bei der Ansteuerung der Gateelektrode G2' des zweiten Einzelelektron-Transistors ET2' sowohl auf dem zweiten Hauptknoten H2' des zweiten Schaltungskreises S2 befindliche Ladung als auch die am ersten Betriebsspannungsanschluß U1 des ersten Schaltungszweiges S1 anliegende Spannung wirksam.

Zum Betrieb der Schaltungsanordnung wird ein Durchlauf mit drei Schritten durchgeführt. Im ersten Schritt wird der erste Betriebsspannungsanschluß U1 des ersten Schaltungszweiges S1 mit 0,17 Volt, der Steuerspannungsanschluß US des ersten Schaltungszweiges S1 mit 0,2 Volt und der erste Betriebsspannungsanschluß U1' sowie der Steuerspannungsanschluß US' des zweiten Schaltungszweiges S2 jeweils mit 0 Volt beaufschlagt. Im zweiten Schritt wird der erste Betriebsspannungsanschluß U1 mit 0,03 Volt, der Steuerspannungsanschluß US mit 0 Volt, der erste Betriebsspannungsanschluß U1' mit 0,1 Volt und der Steuerspannungsanschluß US' mit 0 Volt beaufschlagt. Im dritten Schritt wird der erste Betriebsspannungsanschluß U1 mit - 0,14 Volt, der Steuerspannungsanschluß US mit - 0,1 Volt, der erste Betriebsspannungsanschluß U1' mit 0,12 Volt und der Steuerspannungsanschluß US' mit - 0,1 Volt beaufschlagt.

Nach diesen drei Schritten sind die logischen Werte, die im ersten Hauptknoten H1 und im zweiten Hauptknoten H2 des ersten Schaltungszweiges S1 eingespeichert sind, gemäß der Verknüpfungstabelle

| Information am<br>1. Hauptknoten<br><br>Information<br>am 2. Hauptknoten | 0.. | 1 |
|---|---|---|
| 0 | 00 | 01 |
| 1 | 01 | 10 |

verknüpft, so daß im zweiten Hauptknoten H2 die AND-Verknüpfung der Ausgangsbits und im ersten Hauptknoten H1 die XOR-Verknüpfung vorliegt.

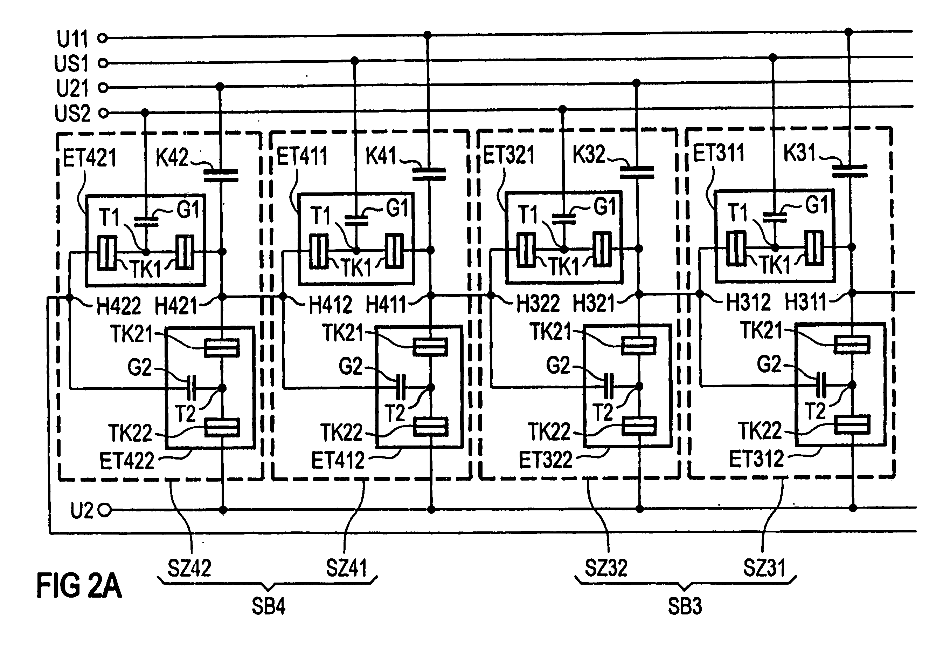

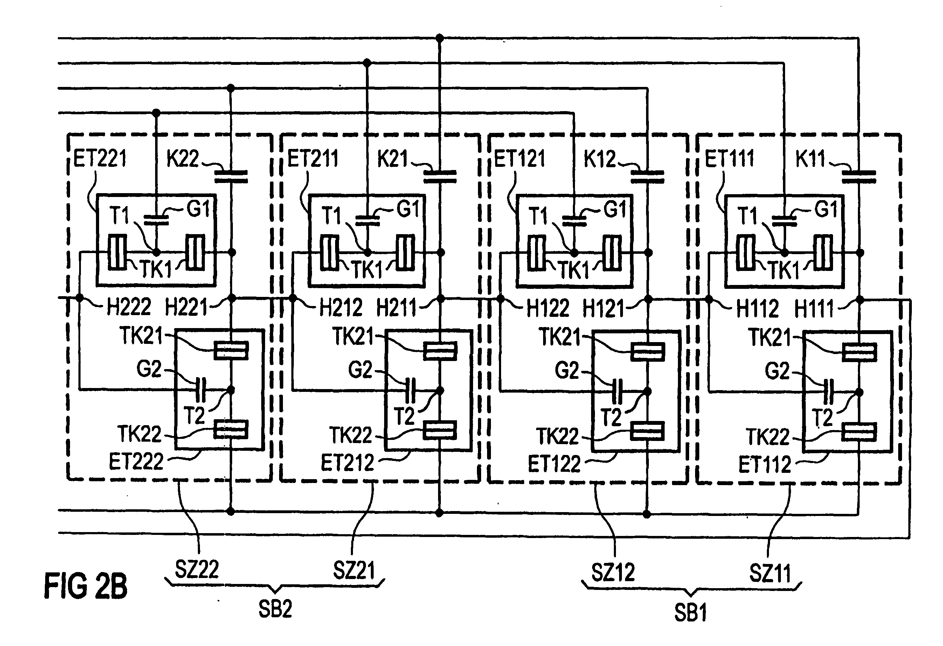

Eine Schaltungsanordnung zur Verknüpfung zweier dreistelliger Binärzahlen durch Addition weist vier Schaltungsblöcke SBi, i = 1, 2, 3, 4 auf (siehe Figur 2). Jeder der Schaltungsblöcke SBi enthält einen ersten Schaltungszweig SZi1 und einen zweiten Schaltungszweig SZi2, i = 1, 2, 3, 4.

Im ersten Schaltungszweig Szi1 sind ein erster Einzelelektron-Transistor ETi11 und ein zweiter Einzelelektron-Transistor ETi12 über einen ersten Hauptknoten Hi11 miteinander in Reihe verschaltet. Der erste Hauptknoten Hi11 ist über einen Kondensator Ki1 mit einem ersten Betriebsspannungsanschluß U11 verbunden. Die Reihenschaltung aus dem ersten Einzelelektron-Transistor ETi11 und dem zweiten Einzelelektron-Transistor ETi12 ist zwischen einen zweiten Hauptknoten Hi12 und einem zweiten Betriebsspannungsanschluß U2 geschaltet. Die Gateelektrode G1 des ersten Einzelelektron-Transistors ETi1 ist mit einem Steuerspannungsanschluß US1 verbunden. Die Gateelektrode G2 des zweiten Einzelelektron-Transistors ETi12 ist mit dem zweiten Hauptknoten Hi12 verbunden. Es gilt dabei jeweils i = 1, 2, 3, 4.

Der zweite Schaltungszweig SZi2 ist analog dem ersten Schaltungszweig SZi1 aufgebaut. Er weist jeweils einen ersten Einzelelektron-Transistor STi21 und einen zweiten Einzelelektron-Transistor ETi22 auf, die über einen ersten Hauptknoten Hi21 miteinander in Reihe verschaltet sind. Der erste Hauptknoten Hi21 ist über einen Kondensator Ki2 mit einem ersten Betriebsspannungsanschluß U21 verbunden. Die Reihenschaltung aus erstem Einzelelektron-Transistor ETi21 und zweitem Einzelelektron-Transistor ETi22 ist zwischen einen zweiten Hauptknoten Hi22 und den zweiten Betriebsspannungsanschluß U2 geschaltet. Die Gateelektrode G1 des ersten Einzelelektron-Transistors ETi21 ist mit einem Steuerspannungsanschluß US2 verbunden. Die Gateelektrode G2 des zweiten Einzelelektron-Transistors ETi22 ist mit dem zweiten Hauptknoten Hi22 verbunden. Dabei gilt jeweils i = 1, 2, 3, 4.

Der zweite Hauptknoten Hi22 des zweiten Schaltungszweigs SZi2 ist für i = 1, 2, 3 jeweils mit dem ersten Hauptknoten Hi+11 des ersten Schaltungszweigs SZi+11 des i+1-ten Schaltungsblocks SBi+1 verbunden. Der zweite Hauptknoten H422 des zweiten Schaltungszweigs SZ42 des vierten Schaltungsblocks SB4 ist mit dem ersten Hauptknoten H111 des ersten Schaltungszweigs SZ11 des ersten Schaltungsblocks SB1 verbunden. Auf diese weise ergibt sich eine zyklische Schaltungsstruktur.

Die ersten Einzelelektron-Transistoren ETi11 der ersten Schaltungszweige SZi1 und die ersten Einzelelektron-Transistoren ETi21 der zweiten Schaltungszweige SZi2 sind jeweils im wesentlichen gleich aufgebaut. Sie weisen ein Tunnelelement T1 auf, das über zwei Tunnelkontakte TK1 mit den benachbarten ersten Hauptknoten Hij1 und zweiten Hauptknoten Hij2, i = 1 bis 4, j = 1, 2 verbunden ist. Das Tunnelelement T1 ist über die Gateelektrode G kapazitiv ansteuerbar.

Die Kondensatoren Kij, i = 1 bis 4, j = 1, 2 sind ebenfalls im wesentlichen gleich aufgebaut.

Die zweiten Einzelelektron-Transistoren ETij2, i = 1 bis 4, j = 1, 2 sind ebenfalls im wesentlichen gleich aufgebaut. Sie weisen jeweils ein Tunnelelement T2 auf, das über einen ersten Tunnelkontakt TK21 mit dem benachbarten ersten Hauptknoten Hij1 verbunden ist und über einen zweiten Tunnelkontakt TK22 mit dem zweiten Betriebsspannungsanschluß U2 verbunden ist. Das Tunnelelement T2 ist über die Gateelektrode G2 kapazitiv ansteuerbar.

Die Kapazitäten der Bestandteile der Einzelelektron-Transistoren ETijk, i = 1 bis 4, j = 1, 2, k = 1, 2 und die Kapazitäten der Kondensatoren Kij, i = 1 bis 4, j = 1, 2 werden zum Beispiel folgendermaßen dimensioniert:

| G1 | Kij | TK1 | G2 | TK21 | TK22 |
|---|---|---|---|---|---|
| 0,4 aF | 0,8 aF | 0, 25 aF | 0,2 aF | 0,4 aF | 0,1 aF |

Zur Verknüpfung zweier Binärzahlen werden alternierend ein erster Durchlauf mit den Schritten 1.1, 1.2, 1.3 und ein zweiter Durchlauf mit den Schritten 2.1, 2.2, 2.3 durchgeführt. Insgesamt werden zur Addition zweier dreistelliger

8

Binärzahlen vier Durchläufe benötigt, wobei die Spannungsverläufe des dritten Durchlaufs identisch mit denen des ersten Durchlaufs sind und die des vierten Durchlaufs identisch mit denen des zweiten. Der zweite Betriebsspannungsanschluß U2 wird dabei auf Erdpotential gelegt. Die ersten Betriebsspannungsanschlüsse U11, U21 und die Steuerspannungsanschlüsse US1, US2 werden in den einzelnen Schritten mit folgenden Spannungspegeln beaufschlagt:

| Schrittnr. Anschluß | 1.1 | 1.2 | 1.3 | 2.1 | 2.2 | 2.3 |
|---|---|---|---|---|---|---|
| U11 [V] | 0,17 | 0,03 | - 0,14 | 0 | 0,1 | 0,12 |
| US1 [V] | 0,2 | 0 | - 0,1 | 0 | 0 | - 0,1 |
| U21 [V] | 0 | 0,1 | 0,12 | 0,17 | 0,03 | - 0,14 |
| US2 [V] | 0 | 0 | - 0,1 | 0,2 | 0 | - 0,1 |

Alternativ werden bei den gleichen Kapazitäten folgende Spannungspegel angelegt.

| Schrittnr. Anschluß | 1.1 | 1.2 | 1.3 | 2.1 | 2.2 | 2.3 |
|---|---|---|---|---|---|---|
| U11 [V] | 0,1 | 0,04 | - 0,12 | - 0,06 | 0,03 | 0,11 |
| US1 [V] | 0,14 | 0,04 | - 0,09 | - 0,03 | 0 | - 0,09 |
| U21 [V] | - 0,06 | 0,03 | 0,11 | 0,1 | 0,04 | - 0,12 |
| US2 [V] | - 0,03 | 0 | - 0,09 | 0,14 | 0,04 | - 0,09 |

Bei einer Dimensionierung der Kapazitäten der Kondensatoren Kij und der Einzelelektron-Transistoren ETijk, i = 1 bis 4, j = 1, 2, k = 1, 2 von

| G1 | Kij | TK1 | G2 | TK21 | TK22 |
|---|---|---|---|---|---|
| 0,5 aF | 0,7 aF | 0,15 aF | 0,1 aF | 0,3 aF | 0,1 aF |

In diesem Fall werden die ersten Betriebsspannungsanschlüsse U11, U21 und die Steuerspannungsanschlüsse US1, US2 mit folgenden Spannungspegeln beaufschlagt

| Schrittnr. Anschluß | 1.1 | 1.2 | 1.3 | 2.1 | 2.2 | 2.3 |
|---|---|---|---|---|---|---|
| U11 [V] | 0,09 | 0,03 | - 0,14 | - 0,08 | 0,01 | 0,03 |
| US1 [V] | 0,07 | - 0,02 | - 0,13 | - 0,08 | - 0,05 | - 0,13 |
| U21 [V] | - 0,08 | 0,01 | 0,03 | 0,09 | 0,03 | - 0,14 |
| US2 [V] | - 0,08 | -0,05 | - 0,13 | 0,07 | - 0,02 | - 0,13 |

Die Erfindung ist nicht auf die angegebenen Kapazitätswerte und Spannungspegel beschränkt. Es liegt im Rahmen fachmännischen Handelns, andere Kapazitätswerte und Spannungspegel zu verwenden.

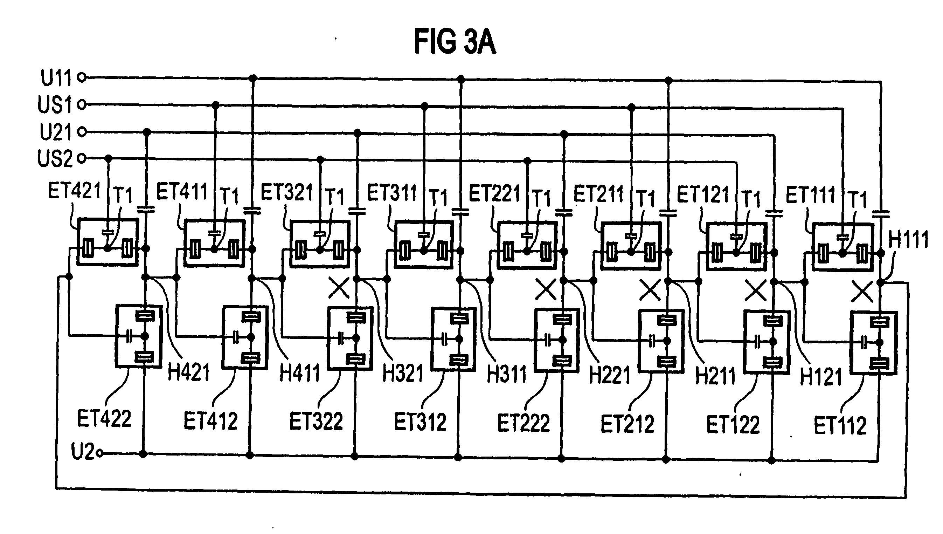

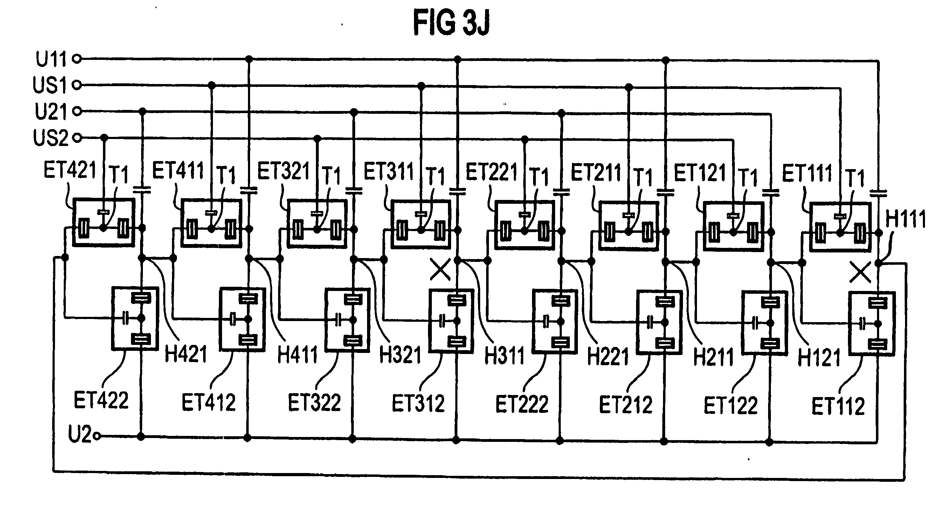

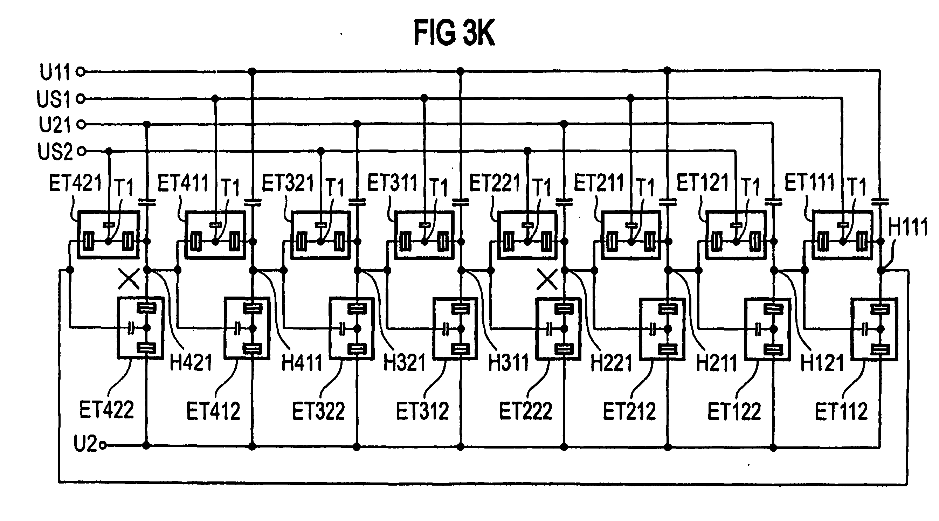

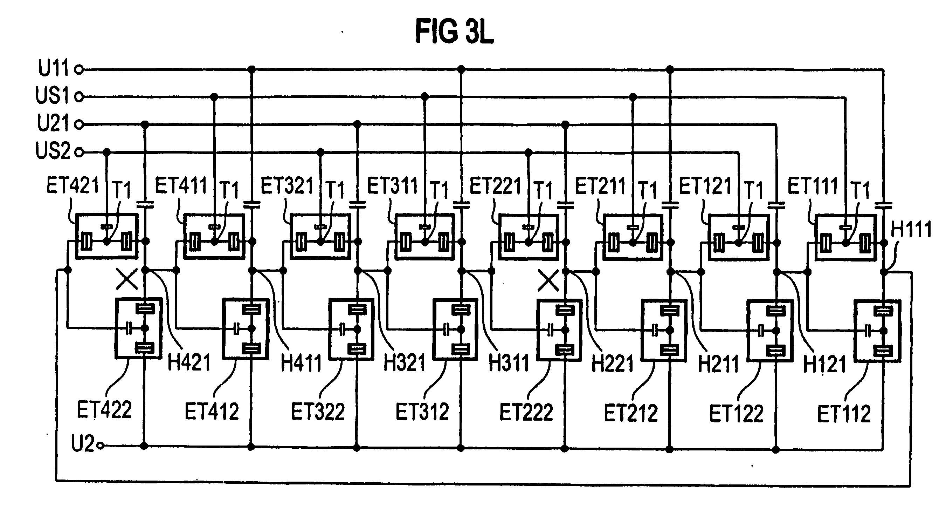

Anhand von Figur 3a bis 31 wird die Addition zweier Binärzahlen mit der anhand von Figur 2 erläuterten Schaltungsanordnung anhand eines Beispiels schrittweise erläutert. Der Übersichtlichkeit halber sind in Figur 3a bis Figur 31 lediglich die ersten Hauptknoten Hij1 die Tunnelelemente T1 der ersten Einzelelektron-Transistoren ETij1 sowie die zweiten Einzelelektron-Transistoren ETij2 bezeichnet. Im übrigen entspricht die dargestellte Schaltungsanordnung jeweils der anhand von Figur 2 geschilderten. Die Anwesenheit eines Elektrons auf einem Hauptknoten oder einem Tunnelelement ist in Figur 3a bis 31 durch x bezeichnet.

Zur Addition der Zahlen 7 + 3, in Binärschreibweise 111 + 011 wird folgendermaßen vorgegangen: die zu addierenden Zahlen werden jeweils in die ersten Hauptknoten Hij1 eingeschrieben. Dabei werden die Stellen des ersten Summanden 3 (011) jeweils in die ersten Hauptknoten Hi11 der ersten Schaltungszweige SZi1 eingeschrieben. Die Stellen des zweiten Summanden 7 (111) werden in die ersten Hauptknoten Hi21 der zweiten Schaltungszweige SZi2 eingeschrieben.Zum besseren Verständnis wird darauf hingewiesen, daß die ersten Hauptknoten H111, H121, H211, H221, H311, H321, H411, H421 jeweils mit dem benachbarten zweiten Hauptknoten H422, H112, H122, H231, H222, H312, H322, H412 verbunden sind und an dem entsprechenden zweiten Hauptknoten somit dieselbe Ladung wirksam ist.

Für eine Eins wird jeweils ein Elektron auf den entsprechenden Hauptknoten aufgebracht, für eine Null wird kein Elektron auf den Hauptknoten aufgebracht. Das Einbringen der Elektronen erfolgt jeweils über den zweiten Betriebsspannungsanschluß U2 bei entsprechender Ansteuerung der Einzelelektron-Transistoren. Der zweite Betriebsspannungsanschluß U2 des jeweiligen Schaltungszweiges SZij wird dazu mit einem entsprechenden Spannungspegel beaufschlagt.

Die ersten Hauptknoten H411 und H421 des vierten Schaltungsblocks SB4 werden mit einer Null beaufschlagt.

Demnach sind die Hauptknoten H421, H411, H311 jeweils mit einer Null, die Hauptknoten H321, H221, H211, H121 und H111 jeweils mit einer Eins beaufschlagt. Es befindet sich somit auf den Hauptknoten H321, H221, H121, H211 und H111 je ein Elektron (siehe Figur 3a).

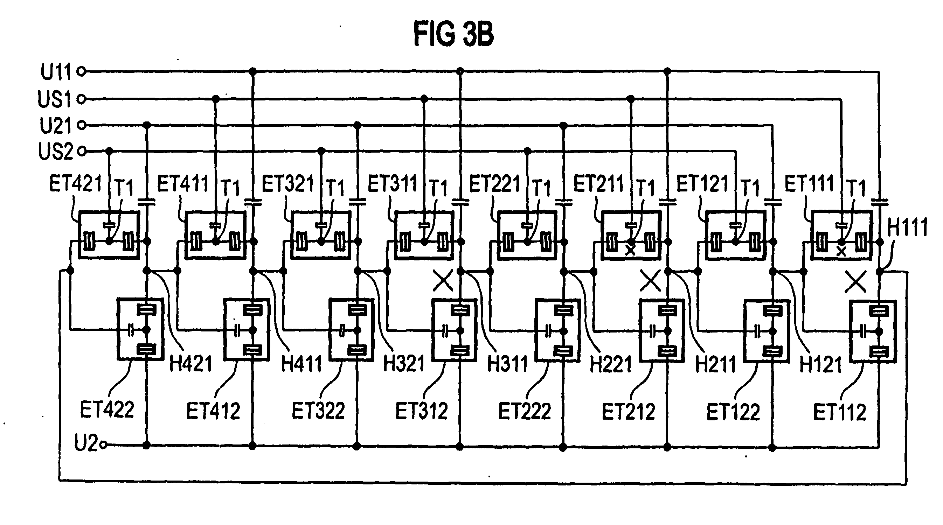

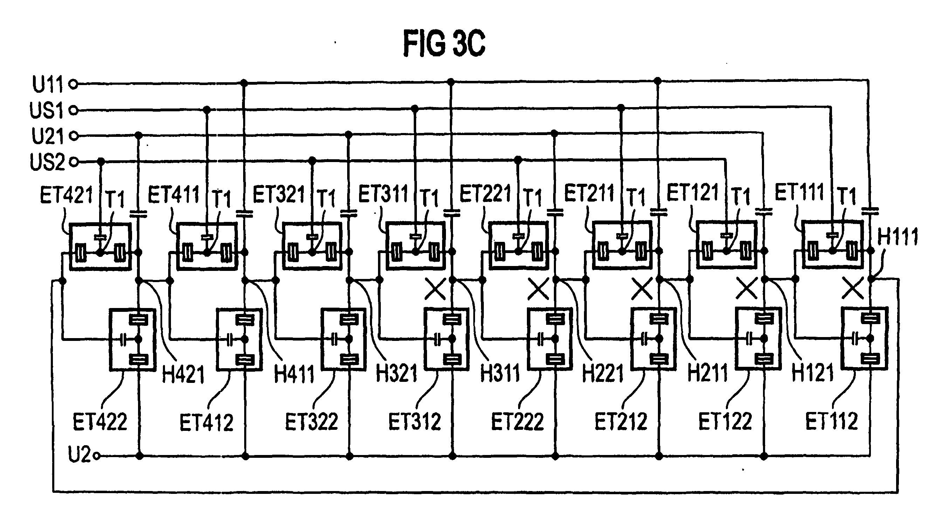

In einem ersten Schritt 1.1 werden Elektronen von dem ersten Hauptknoten Hi21 der zweiten Schaltungszweige SZi2 auf das Tunnelelement T1 des ersten Einzelelektron-Transistors ETi11 verschoben, sofern der zugehörige erste Hauptknoten Hi11 mit einem Elektron besetzt ist. Ist der zugehörige Hauptknoten Hi11 des ersten Schaltungszweiges SZi1 nicht mit einem Elektron besetzt, wird das Elektron von dem ersten Hauptknoten Hi21 des zweiten Schaltungszweiges SZi2 auf den ersten Hauptknoten Hi11 des ersten Schaltungszweiges SZi1 verschoben. Dadurch ergibt sich die in Figur 3b dargestellte Situation. Es befindet sich somit auf den Hauptknoten H311, H211, H111 und den Tunnelelementen T1 der Einzelelektron-Transistoren ET211 und ET111 je ein Elektron.

Im Schritt 1.2 werden Elektronen von dem Tunnelelement T1 des Einzelelektron-Transistors ETi11 auf den zugehörigen ersten Hauptknoten Hi21 des zweiten Schaltungszweiges SZi2 verschoben. Es ergibt sich die in Figur 3c dargestellte Situation. Es befindet sich auf den Hauptknoten H311, H211, H111, H221, H121 je ein Elektron.

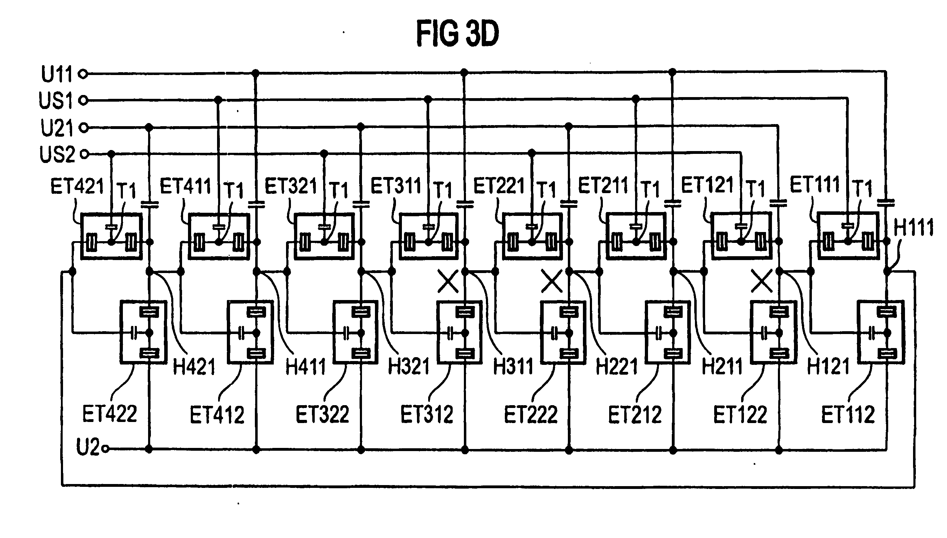

Im Schritt 1.3 werden in den Schaltungsblöcken SBi, in denen sowohl der erste Hauptknoten Hi21 des zweiten Schaltungszweiges SZi2 als auch der erste Hauptknoten Hi11 des ersten Schaltungszweiges SZi1 mit einem Elektron besetzt sind, die zweiten Einzelelektron-Transistoren ETi12 so angesteuert, daß das Elektron von dem ersten Hauptknoten Hi11 zum zweiten Betriebsspannungsanschluß U2 fließt. Es ergibt sich die in Figur 3d dargestellte Situation.Es befindet sich auf den Hauptknoten H311, H221, H121 je ein Elektron.

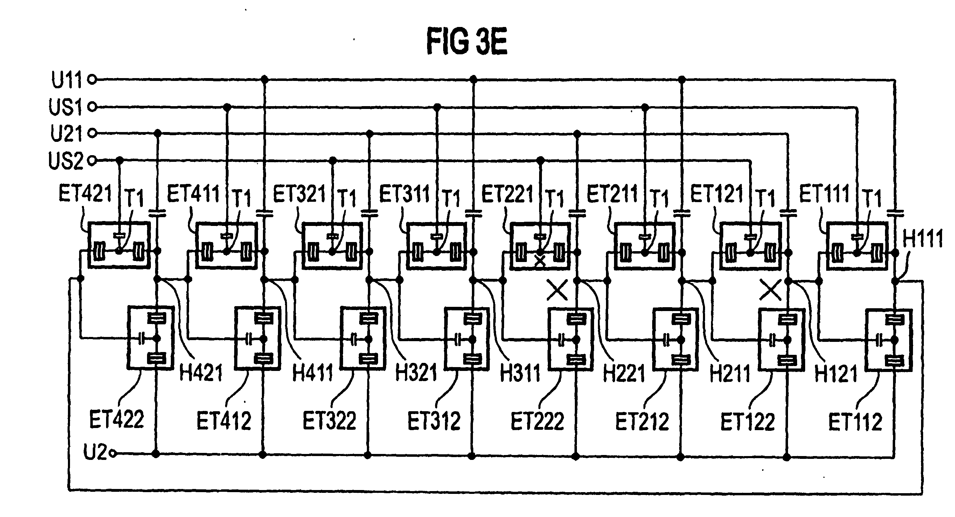

Nachfolgend wird der Schritt 2.1 durchgeführt, der analog zum Schritt 1.1 abläuft, bei dem jedoch die Rolle der ersten Schaltungszweige SZi1 mit der der zweiten Schaltungszweige SZi2 vertauscht ist. Dabei wird ein Elektron von den ersten Hauptknoten H411, H311, H211, H111 auf das Tunnelelement T1 des ersten Einzelelektron-Transistors ET321, ET221, ET121, ET421 des jeweiligen zweiten Schaltungszweiges SZi2 bzw. auf den ersten Hauptknoten H321, H221, H121, H421 verschoben, abhängig davon, ob sich auf dem zweiten Hauptknoten ein Elektron befindet oder nicht. Es ergibt sich die in Figur 3e darstellte Situation. Es befindet sich auf den Hauptknoten H221, H121 und auf dem Tunnelelement T1 des Einzelelektron-Transistors ET221 je ein Elektron.

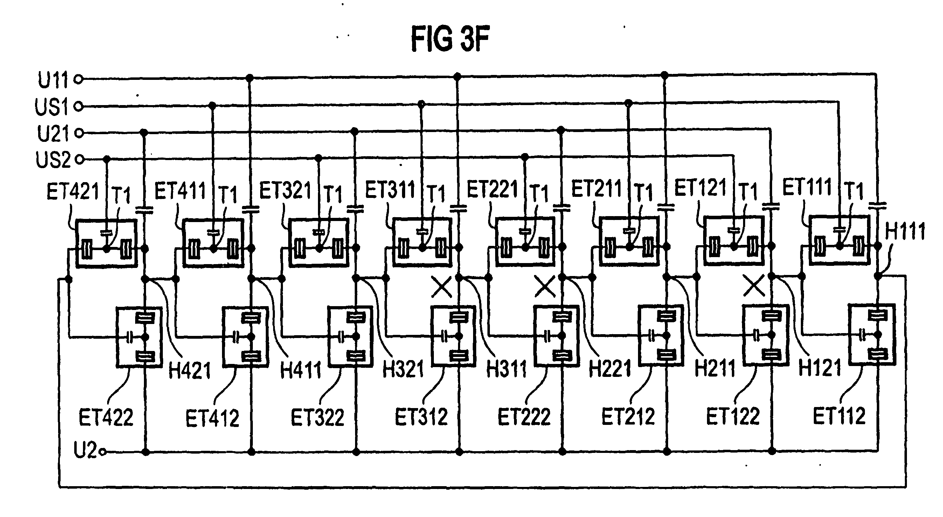

Im Schritt 2.2 werden nun die auf Tunnelelementen T1 befindlichen Elektronen auf den benachbarten ersten Hauptknoten H411, H311, H211, H111 geschoben, sofern der benachbarte erste Hauptknoten H321, H221, H121, H421 mit einem Elektron versehen ist. Es ergibt sich Figur 3f. Es befindet sich auf den Hauptknoten H311, H221, H121 je ein Elektron.

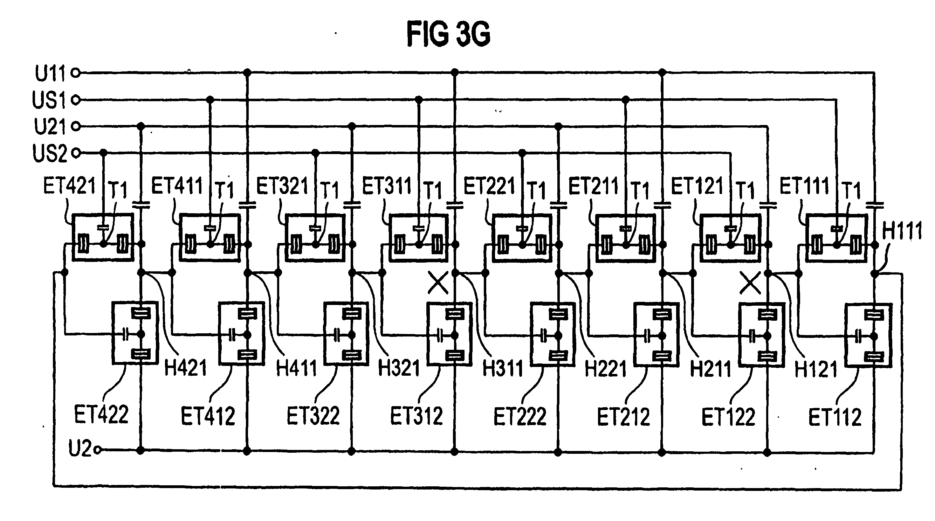

Im Schritt 2.3 werden Elektronen, die sich auf dem zweiten Hauptknoten H321, H221, H121, H421 befinden, zum zweiten Betriebsspannungsanschluß U2 abgeführt, sofern sich auf den benachbarten ersten Hauptknoten H411, H311, H211, H111 jeweils ein Elektron befindet. Es ergibt sich die in Figur 3g dargestellte Situation. Es befindet sich auf den Hauptknoten H311, H121 je ein Elektron.

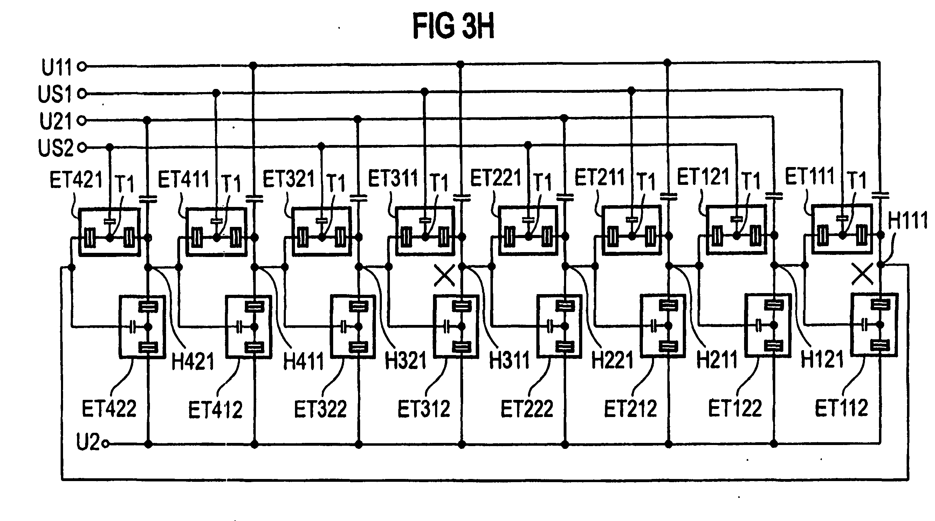

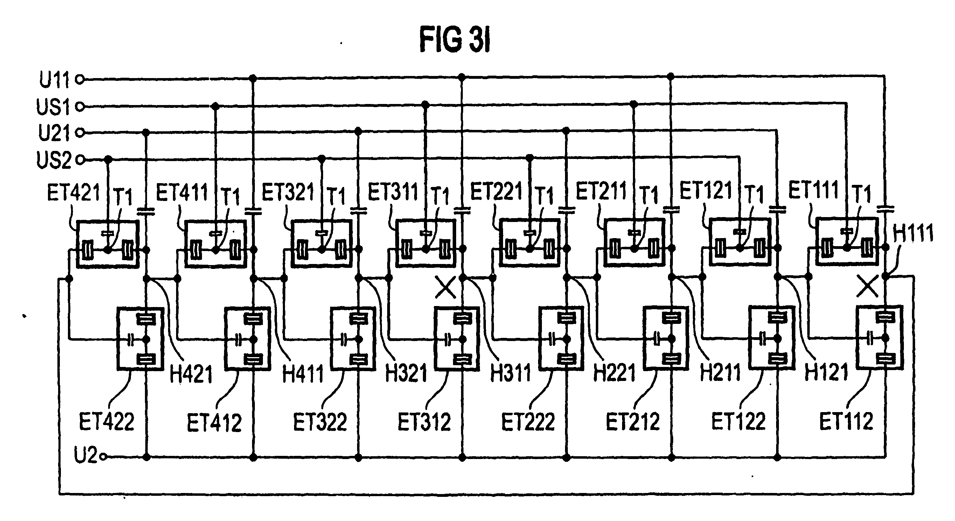

Anschließend wird der Schritt 1.1 durchgeführt, wobei sich die in Figur 3h dargestellte Situation ergibt. Es befindet sich auf den Hauptknoten H311, H111 je ein Elektron.

Anschließend wird der Schritt 1.2 durchgeführt, wobei sich die in Figur 3i dargestellte Situation ergibt. Es befindet sich auf den Hauptknoten H311, H111 je ein Elektron. Da sich in diesem Beispiel nach diesem Schritt 1.1 keine Elektronen auf Tunnelelementen befinden, ändert sich in diesem Schritt nichts.

Anschließend wird der Schritt 1.3 durchgeführt, wobei sich die in Figur 3j dargestellte Situation ergibt. Es befindet sich auf den Hauptknoten H311, H111 je ein Elektron. Da sich in diesem Beispiel nach diesem Schritt 1.2 keine Elektronen auf beanchbarten ersten Hauptknoten befinden, ändert sich in diesem Schritt nichts.

Anschließend wird der Schritt 2.1 durchgeführt, wobei sich die in Figur 3k dargestellte Situation ergibt. Es befindet sich auf den Hauptknoten H421, H221 je ein Elektron.

Die Anwendung der Schritte 2.2 und 2.3 verändert die Ladung der Hauptknoten in diesem Beispiel nicht mehr, so daß sich das in Figur 31 dargestellte Resultat ergibt. Es befindet sich auf den Hauptknoten H421, H221 je ein Elektron. Die Hauptknoten Hi11 sind mit Null besetzt. Die Stellen der Summenzahl sind den ersten Hauptknoten Hi21 der zweiten Schaltungszweige SZi2 zu entnehmen. Die Stellen sind gegenüber der ursprünglichen Lage um zwei Schaltungsblöcke verschoben. Bei der Addition werden in den Schritten 1.1, 1.2, 1.3, 2.1, 2.2, 2.3 die im Zusammenhang mit Figur 2 angegebenen Spannungspegel verwendet.

## Patentansprüche

1. Schaltungsanordnung mit Einzelelektron-Bauelementen,

   - bei der mindestens ein erster Einzelelektron-Transistor (ET1), ein erster Hauptknoten (H1) und ein zweiter Hauptknoten (H2) vorgesehen sind, wobei der erste Hauptknoten und der zweite Hauptknoten über den ersten Einzelelektron-Transistor elektrisch verbindbar sind,
   - bei der die Gateelektrode (G1) des ersten Einzelelektron-Transistors mit einem Steuerspannungsanschluß (US) verbunden ist,
   - bei der der erste Hauptknoten jeweils über eine Kapazität (K) mit einem ersten Betriebsspannungsanschluß (H1) verbunden ist und mit einem zweiten Betriebsspannungsanschluß (H2) verbindbar ist,
   - bei der ein zweiter Einzelelektron-Transistor (ET2) vorgesehen ist, über den der erste Hauptknoten (H1) und der zweite Betriebsspannungsanschluß (U2) elektrisch verbindbar sind und dessen Gateelektrode (G2) mit dem zweiten Hauptknoten verbunden ist.

2. Schaltungsanordnung nach Anspruch 1,

   - bei der mindestens ein erster Schaltungszweig und ein zweiter Schaltungszweig vorgesehen sind,
   - bei der der erste Schaltungszweig und zweite Schaltungszweig jeweils einen ersten Einzelelektron-Transistor und einen zweiten Einzelelektron-Transistor aufweisen, die über einen ersten Hauptknoten miteinander in Reihe verbunden sind,
   - bei der der erste Hauptknoten über einen Kondensator mit einem ersten Betriebsspannungsanschluß verbunden ist,
   - bei der ein zweiter Hauptknoten und ein zweiter Betriebsspannungsanschluß über die in Reihe verbundenen ersten und zweiten Einzelelektron-Transistoren miteinander elektrisch verbindbar sind,
   - bei der die Gateelektrode des ersten Einzelelektron-Transistors mit einem Steuerspannungsanschluß verbunden ist,
   - bei der die Gateelektrode des zweiten Einzelelektron-Transistors mit dem zweiten Hauptknoten verbunden ist,
   - bei der der erste Hauptknoten des zweiten Schaltungszweigs mit dem zweiten Hauptknoten des ersten Schaltungszweigs verbunden ist.

3. Schaltungsanordnung nach Anspruch 2,
   bei der der zweite Hauptknoten des zweiten Schaltungszweigs mit dem ersten Hauptknoten des ersten Schaltungszweigs verbunden ist.

4. Schaltungsanordnung nach Anspruch 2,

   - bei der n Schaltungsblöcke mit jeweils einem ersten Schaltungszweig und einem zweiten Schaltungszweig vorgesehen sind, wobei n größer oder gleich 2 ist und wobei der erste Schaltungszweig und der zweite Schaltungszweig jeweils einen ersten Einzelelektron-Transistor und einen zweiten Einzelelektron-Transistor aufweisen, die über einen ersten Hauptknoten miteinander in Reihe verbunden sind,
   - wobei der erste Hauptknoten über einen Kondensator mit einem ersten Betriebsspannungsanschluß verbunden ist,
   - wobei ein zweiter Hauptknoten und ein zweiter Betriebsspannungsanschluß über die in Reihe verbundenen ersten und zweiten Einzelelektron-Transistoren miteinander verbindbar sind,
- wobei die Gateelektrode des ersten Einzelelektron-Transistors mit einem Steuerspannungsanschluß verbunden ist,
- wobei die Gateelektrode des zweiten Einzelelektron-Transistors mit einem zweiten Hauptknoten verbunden ist,
- wobei der erste Hauptknoten des zweiten Schaltungszweigs mit dem zweiten Hauptknoten des ersten Schaltungszweigs verbunden ist,
- bei der der zweite Hauptknoten des zweiten Schaltungszweigs des i-ten Schaltungsblocks, i = 1, .... n - 1 jeweils mit dem ersten Hauptknoten des ersten Schaltungszweigs des i + 1-ten Schaltungsblocks verbunden ist,
- bei der der zweite Hauptknoten des zweiten Schaltungszweigs des n-ten Schaltungsblocks mit dem ersten Hauptknoten des ersten Schaltungszweigs des ersten Schaltungsblocks verbunden ist.

5. Schaltungsanordnung nach einem der Ansprüche 2 bis 4,
bei der der Kondensator, der erste Einzelelektron-Tränsistor und der zweite Einzelelektron-Transistor im ersten Schaltungszweig und im zweiten Schaltungszweig im wesentlichen die gleiche elektrische Dimensionierung aufweisen.

6. Schaltungsanordnung nach einem der Ansprüche 2 bis 5,

- bei der der erste Einzelelektron-Transistor zwei Tunnelkontakte mit im wesentlichen gleicher Kapazität aufweist,
- bei der der zweite Einzelelektron-Transistor zwei Tunnelkontakte mit unterschiedlicher Kapazität aufweist.

7. Schaltungsanordnung nach einem der Ansprüche 2 bis 5,
bei der der zweite Betriebsspannungsanschluß im ersten Schaltungszweig mit dem zweiten Betriebsspannungsanschluß im zweiten Schaltungszweig jeweils verbunden ist.

8. Verfahren zum Betrieb einer Schaltungsanordnung nach einem der Ansprüche 2 bis 7,

- bei dem an den ersten Betriebsspannungsanschluß des ersten Schaltungszweiges jeweils ein erster Spannungspegel, an den Steueranschluß des ersten Schaltungszweiges jeweils ein zweiter Spannungspegel, an den ersten Betriebsspannungsanschluß des zweiten Schaltungszweiges jeweils ein dritter Spannungspegel und an der Steueranschluß des zweiten Schaltungszweiges jeweils ein vierter Spannungspegel angelegt wird,
- bei dem in einem ersten Schritt die Werte für den ersten Spannungspegel, den zweiten Spannungspegel, den dritten Spannungspegel und den vierten Spannungspegel so eingestellt werden, daß auf dem zweiten Hauptknoten des ersten Schaltungszweigs befindliche Ladungsträger auf den ersten Hauptknoten des ersten Schaltungszweigs fließen, sofern sich auf dem ersten Hauptknoten zuvor kein Ladungsträger befindet und daß auf dem zweiten Hauptknoten des ersten Schaltungszweiges befindliche Ladungsträger auf den Tunnelübergang des ersten Einzelelektron-Transistors des ersten Schaltungszweiges fließen, sofern sich auf dem ersten Hauptknoten des ersten Schaltungszweiges ein Ladungsträger befindet,
- bei dem in einem zweiten Schritt die Werte für den ersten Spannungspegel, den zweiten Spannungspegel, den dritten Spannungspegel und den vierten Spannungspegel so eingestellt werden, daß auf dem Tunnelübergang des ersten Einzelelektron-Transistors des ersten Schaltungszweiges befindliche Ladungsträger auf den zweiten Hauptknoten des ersten Schaltungszweiges fließen,
- bei dem in einem dritten Schritt die Werte für den ersten Spannungspegel, den zweiten Spannungspegel, den dritten Spannungspegel und den vierten Spannungspegel so eingestellt werden, daß auf dem ersten Hauptknoten des ersten Schaltungszweiges befindliche Ladungsträger über den zweiten Einzelelektron-Transistor zum zweiten Betriebsspannungsanschluß fließen, sofern sich auf dem zweiten Hauptknoten des ersten Schaltungszweiges ein Ladungsträger befindet.

9. Verfahren nach Anspruch 8,

- bei dem in einem ersten Durchlauf an den ersten Betriebsspannungsanschluß des ersten Schaltungszweiges jeweils ein erster Spannungspegel, an den Steueranschluß des ersten Schaltungszweiges jeweils ein zweiter Spannungspegel, an den ersten Betriebsspannungsanschluß des zweiten Schaltungszweiges jeweils ein dritter Spannungspegel und an den Steueranschluß des zweiten Schaltungszweiges jeweils ein vierter Spannungspegel angelegt wird,
- bei dem in einem ersten Schritt die Werte für den ersten Spannungspegel, den zweiten Spannungspegel, den dritten Spannungspegel und den vierten Spannungspegel so eingestellt werden, daß auf dem zweiten Hauptknoten des ersten Schaltungszweigs befindliche Ladungsträger auf den ersten Hauptknoten des ersten Schaltungszweiges fließen, sofern sich auf diesem ersten Hauptknoten zuvor kein Ladungsträger befindet und daß auf dem zweiten Hauptknoten des ersten Schaltungszweiges befindliche Ladungsträger auf den Tunnelübergang des ersten Einzelelektron-Transistors des ersten Schaltungszweiges fließen, sofern sich auf dem ersten Hauptknoten des ersten Schaltungszweiges ein Ladungsträger befindet,

- bei dem in einem zweiten Schritt die Werte für den ersten Spannungspegel, den zweiten Spannungspegel, den dritten Spannungspegel und den vierten Spannungspegel so eingestellt werden, daß auf dem Tunnelübergang des ersten Einzelelektron-Transistors des ersten Schaltungszweiges befindliche Ladungsträger auf den zweiten Hauptknoten des ersten Schaltungszweiges abfließen,

- bei dem in einem dritten Schritt die Werte für den ersten Spannungspegel, den zweiten Spannungspegel, den dritten spannungspegel und den vierten Spannungspegel so eingestellt werden, daß auf dem ersten Hauptknoten des ersten Schaltungszweiges befindliche Ladungsträger über den zweiten Einzelelektron-Transistor zum zweiten Betriebsspannungsanschluß fließen, sofern sich auf dem zweiten Hauptknoten des ersten Schaltungszweiges ein Ladungsträger befindet,

- bei dem in einem zweiten Durchlauf an den ersten Betriebsspannungsanschluß des ersten Schaltungszweiges der dritte Spannungspegel, an den Steueranschluß des ersten Schaltungszweiges der vierte Spannungspegel, an den ersten Betriebsspannungsanschluß des zweiten Schaltungszweiges der erste Spannungspegel und an den Steueranschluß des zweiten Schaltungszweiges der zweite Spannungspegel angelegt wird,

- bei dem in einem ersten Schritt die Werte für den ersten Spannungspegel, den zweiten Spannungspegel, den dritten Spannungspegel und den vierten Spannungspegel auf die im ersten Schritt des ersten Durchlaufs verwendeten Werte eingestellt werden,

- bei dem in einem zweiten Schritt die Werte für den ersten Spannungspegel, den zweiten Spannungspegel, den dritten Spannungspegel und den vierten Spannungspegel auf die im zweiten Schritt des ersten Durchlaufs verwendeten Werte eingestellt werden,

- bei dem in einem dritten Schritt die Werte für den ersten Spannungspegel, den zweiten Spannungspegel, den dritten Spannungspegel und den vierten Spannungspegel auf die im dritten Schritt des ersten Durchlaufs verwendeten Werte eingestellt werden.

**10.** Verfahren nach Anspruch 9,
bei dem der erste Durchlauf und der zweite Durchlauf alternierend angewendet werden.

**11.** Anwendung des Verfahrens nach Anspruch 9 oder 10 zur Addition von Binärzahlen.


**Claims**

**1.** Circuit arrangement having single-electron components,

- in which at least one first single-electron transistor (ET1), one first main node (H1) and one second main node (H2) are provided, in which case the first main node and the second main node can be electrically connected via the first single-electron transistor,
- in which the gate electrode (G1) of the first single-electron transistor is connected to a control voltage connection (US),
- in which the first main node is in each case connected via a capacitance (K) to a first operating voltage connection (U1) and may be connected to a second operating voltage connection (U2),
- in which a second single-electron transistor (ET2) is provided, via which the first main node (H1) and the second operating voltage connection (U2) can be electrically connected, and whose gate electrode (G2) is connected to the second main node.

**2.** Circuit arrangement according to Claim 1,

- in which at least one first circuit path and one second circuit path are provided,
- in which the first circuit path and second circuit path each have a first single-electron transistor and a second single-electron transistor, which are connected in series with one another via a first main node,
- in which the first main node is connected via a capacitor to a first operating voltage connection,
- in which a second main node and a second operating voltage connection can be electrically connected to one another via the series-connected first and second single-electron transistors,
- in which the gate electrode of the first single-electron transistor is connected to a control voltage connection,

13

- in which the gate electrode of the second single-electron transistor is connected to the second main node, and
- in which the first main node in the second circuit path is connected to the second main node in the first circuit path.

3. Circuit arrangement according to Claim 2,
   in which the second main node in the second circuit path is connected to the first main node in the first circuit path.

4. Circuit arrangement according to Claim 2,

   - in which n circuit blocks are provided, each having a first circuit path and a second circuit path, with n being greater than or equal to 2 and with the first circuit path and the second circuit path each having a first single-electron transistor and a second single-electron transistor which are connected in series with one another via a first main node,
   - with the first main node being connected via a capacitor to a first operating voltage connection,
   - in which case a second main node and a second operating voltage connection can be connected to one another via the series-connected first and second single-electron transistors,
   - with the gate electrode of the first single-electron transistor being connected to a control voltage connection,
   - with the gate electrode of the second single-electron transistor being connected to a second main node,
   - with the first main node in the second circuit path being connected to the second main node in the first circuit path,
   - in which the second main node in the second circuit path of the i-th circuit block, i = 1, .... n - 1 is respectively connected to the first main node in the first circuit path of the i + 1-th circuit block, and
   - in which the second main node in the second circuit path of the n-th circuit block is connected to the first main node in the first circuit path of the first circuit block.

5. Circuit arrangement according to one of Claims 2 to 4, in which the capacitor, the first single-electron transistor and the second single-electron transistor in the first circuit path and in the second circuit path are essentially designed to be electrically identical.

6. Circuit arrangement according to one of Claims 2 to 5,

   - in which the first single-electron transistor has two tunnel contacts having essentially the same capacitance, and
   - in which the second single-electron transistor has two tunnel contacts having a different capacitance.

7. Circuit arrangement according to one of Claims 2 to 5, in which the second operating voltage connection in the first circuit path is respectively connected to the second operating voltage connection in the second circuit path.

8. Method for operating a circuit arrangement according to one of Claims 2 to 7,

   - in which a first voltage level is in each case applied to the first operating voltage connection in the first circuit path, a second voltage level is in each case applied to the control connection in the first circuit path, a third voltage level is in each case applied to the first operating voltage connection in the second circuit path, and a fourth voltage level is in each case applied to the control connection in the second circuit path,
   - in which, in a first step, the values for the first voltage level, the second voltage level, the third voltage level and the fourth voltage level are set such that charge carriers which are located at the second main node in the first circuit path flow to the first main node in the first circuit path, provided no charge carriers are already located at the first main node, and such that charge carriers which are located at the second main node in the first circuit path flow to the tunnel junction of the first single-electron transistor in the first circuit path, provided a charge carrier is located at the first main node in the first circuit path,
   - in which, in a second step, the values for the first voltage level, the second voltage level, the third voltage level and the fourth voltage level are set such that charge carriers which are located at the tunnel junction of the first single-electron transistor in the first circuit path flow to the second main node in the first circuit path, and
   - in which, in a third step, the values for the first voltage level, the second voltage level, the third voltage level and the fourth voltage level are set such that charge carriers which are located at the first main node in the first circuit path flow via the second single-electron transistor to the second operating voltage connection, provided a charge carrier is located at the second main node in the first circuit path.

9. Method according to Claim 8,

   - in which, in a first run, a first voltage level is in each case applied to the first operating voltage connection in the first circuit path, a second voltage level is in each case applied to the control connection in the first circuit path, a third voltage level is in each case applied to the first operating voltage connection in the second circuit path, and a fourth voltage level is in each case applied to the control connection in the second circuit path,

- in which, in a first step, the values for the first voltage level, the second voltage level, the third voltage level and the fourth voltage level are set such that charge carriers which are located at the second main node in the first circuit path flow to the first main node in the first circuit path provided no charge carriers are already located at this first main node, and such that charge carriers which are located at the second main node in the first circuit path flow to the tunnel junction of the first single-electron transistor in the first circuit path, provided a charge carrier is located at the first main node in the first circuit path,

- in which, in a second step, the values for the first voltage level, the second voltage level, the third voltage level and the fourth voltage level are set such that charge carriers which are located at the tunnel junction of the first single-electron transistor in the first circuit path flow away to the second main node in the first circuit path,

- in which, in a third step, the values for the first voltage level, the second voltage level, the third voltage level and the fourth voltage level are set such that charge carriers which are located at the first main node in the first circuit path flow via the second single-electron transistor to the second operating voltage connection, provided a charge carrier is located at the second main node in the first circuit path,

- in which, in a second run, the third voltage level is applied to the first operating voltage connection in the first circuit path, the fourth voltage level is applied to the control connection in the first circuit path, the first voltage level is applied to the first operating voltage connection in the second circuit path, and the second voltage level is applied to the control connection in the second circuit path,

- in which, in a first step, the values for the first voltage level, the second voltage level, the third voltage level and the fourth voltage level are set to the values used in the first step of the first run,

- in which, in a second step, the values for the first voltage level, the second voltage level, the third voltage level and the fourth voltage level are set to the values used in the second step of the first run, and

- in which, in a third step, the values for the first voltage level, the second voltage level, the third voltage level and the fourth voltage level are set to the values used in the third step of the first run.

**10.** Method according to Claim 9,
in which the first run and the second run are used alternately.

**11.** Use of the method according to Claim 9 or 10 for addition of binary numbers.


**Revendications**

**1.** Circuit avec des composants à électron unique,

- avec lequel au moins un premier transistor à électron unique (ET1), un premier noeud principal (H1) et un deuxième noeud principal (H2) sont prévus, de sorte que le premier noeud principal et le deuxième noeud principal peuvent être connectés électriquement via le premier transistor à électron unique,
- avec lequel l'électrode de grille (G1) du premier transistor à électron unique est connectée à une borne de tension de gâchette (US),
- avec lequel le premier noeud principal peut être respectivement connecté via une capacité (K) à une première borne de tension de service (U1) et à une deuxième borne de tension de service (U2),
- avec lequel un deuxième transistor à électron unique (ET2) est prévu, via lequel le premier noeud principal (H1) et la deuxième borne de tension de service (U2) peuvent être connectés électriquement, et dont l'électrode de grille (G2) est connectée au deuxième noeud principal.

**2.** Circuit selon la revendication 1,

- avec lequel au moins un premier bras de circuit et un deuxième bras de circuit sont prévus,
- avec lequel le premier bras de circuit et le deuxième bras de circuit présentent respectivement un premier transistor à électron unique et un deuxième transistor à électron unique, lesquels sont connectés ensemble en série via un premier noeud principal,
- avec lequel le premier noeud principal est connecté via un condensateur à une première borne de tension de service,
- avec lequel un deuxième noeud principal et une deuxième borne de tension de service peuvent être connectés ensemble électriquement via le premier et le deuxième transistors à électron unique connectés en série,

- avec lequel l'électrode de grille du premier transistor à électron unique est connectée à une borne de tension de gâchette,
- avec lequel l'électrode de grille du deuxième transistor à électron unique est connectée au deuxième noeud principal,
- avec lequel le premier noeud principal du deuxième bras de circuit est connecté au deuxième noeud principal du premier bras de circuit.

3.  Circuit selon la revendication 2,
    avec lequel le deuxième noeud principal du deuxième bras de circuit est connecté au premier noeud principal du premier bras de circuit.

4.  Circuit selon la revendication 2,

    - avec lequel n blocs circuit avec respectivement un premier bras de circuit et un deuxième bras de circuit sont prévus, de sorte que n est supérieur ou égal à 2 et de sorte que le premier bras de circuit et le deuxième bras de circuit présentent respectivement un premier transistor à électron unique et un deuxième transistor à électron unique, lesquels sont connectés ensemble en série via un premier noeud principal,
    - moyennant quoi le premier noeud principal est connecté via un condensateur à une première borne de tension de service,
    - moyennant quoi un deuxième noeud principal et une deuxième borne de tension de service peuvent être connectés ensemble via le premier et le deuxième transistors à électron unique connectés en série,
    - moyennant quoi l'électrode de grille du premier transistor à électron unique est connectée à une borne de tension de gâchette,
    - moyennant quoi l'électrode de grille du deuxième transistor à électron unique est connectée à un deuxième noeud principal,
    - moyennant quoi le premier noeud principal du deuxième bras de circuit est connecté au deuxième noeud principal du premier bras de circuit,
    - avec lequel le deuxième noeud principal du deuxième bras de circuit du i-ème bloc circuit, i = 1, ..., n - 1 est respectivement connecté au premier noeud principal du premier bras de circuit du i + 1$^{er}$ bloc circuit,
    - avec lequel le deuxième noeud principal du deuxième bras de circuit du n-ème bloc circuit est connecté au premier noeud principal du premier bras de circuit du premier bloc circuit.

5.  Circuit selon l'une quelconque des revendications 2 à 4, avec lequel le condensateur, le premier transistor à électron unique et le deuxième transistor à électron unique dans le premier bras de circuit et le deuxième bras de circuit présentent essentiellement le même dimensionnement électrique.

6.  Circuit selon l'une quelconque des revendications 2 à 5,

    - avec lequel le premier transistor à électron unique présente deux contacts à effet tunnel avec essentiellement une même capacité,
    - avec lequel le deuxième transistor à électron unique présente deux contacts à effet tunnel de capacités différentes.

7.  Circuit selon l'une quelconque des revendications 2 à 5, avec lequel la deuxième borne de tension de service dans le premier bras de circuit est respectivement connectée à la deuxième borne de tension de service dans le deuxième bras de circuit.

8.  Procédé pour l'exploitation d'un circuit selon l'une quelconque des revendications 2 à 7,

    - avec lequel on applique respectivement un premier niveau de tension à la première borne de tension de service du premier bras de circuit, respectivement un deuxième niveau de tension à la borne de gâchette du premier bras de circuit, respectivement un troisième niveau de tension à la première borne de tension de service du deuxième bras de circuit, et respectivement un quatrième niveau de tension à la borne de gâchette du deuxième bras de circuit,
    - avec lequel au cours d'une première étape, les valeurs pour le premier niveau de tension, le deuxième niveau de tension, le troisième niveau de tension et le quatrième niveau de tension sont réglées de manière à ce que des porteurs de charge se trouvant sur le deuxième noeud principal du premier bras de circuit circulent vers le premier noeud principal du premier bras de circuit, dans la mesure où aucun porteur de charge ne se trouvait préalablement sur le premier noeud principal, et de manière à ce que des porteurs de charge se trouvant sur le deuxième noeud principal du premier bras de circuit circulent vers la jonction à effet tunnel du premier transistor à électron unique du premier bras de circuit, dans la mesure où un porteur de charge se trouve sur le premier noeud principal du premier bras de circuit,

- avec lequel au cours d'une deuxième étape, les valeurs pour le premier niveau de tension, le deuxième niveau de tension, le troisième niveau de tension et le quatrième niveau de tension sont réglées de manière à ce que des porteurs de charge se trouvant sur la jonction à effet tunnel du premier transistor à électron unique du premier bras de circuit circulent vers le deuxième noeud principal du premier bras de circuit,

- avec lequel au cours d'une troisième étape, les valeurs pour le premier niveau de tension, le deuxième niveau de tension, le troisième niveau de tension et le quatrième niveau de tension sont réglées de manière à ce que des porteurs de charge se trouvant sur le premier noeud principal du premier bras de circuit circulent via le deuxième transistor à électron unique vers la deuxième borne de tension de service, dans la mesure où un porteur de charge se trouve sur le deuxième noeud principal du premier bras de circuit.

9. Procédé selon la revendication 8,

- avec lequel on applique, au cours d'un premier déroulement, respectivement un premier niveau de tension à la première borne de tension de service du premier bras de circuit, respectivement un deuxième niveau de tension à la borne de gâchette du premier bras de circuit, respectivement un troisième niveau de tension à la première borne de tension de service du deuxième bras de circuit, et respectivement un quatrième niveau de tension à la borne de gâchette du deuxième bras de circuit du deuxième bras de circuit,

- avec lequel au cours d'une première étape, les valeurs pour le premier niveau de tension, le deuxième niveau de tension, le troisième niveau de tension et le quatrième niveau de tension sont réglées de manière à ce que des porteurs de charge se trouvant sur le deuxième noeud principal du premier bras de circuit circulent vers le premier noeud principal du premier bras de circuit, dans la mesure où aucun porteur de charge ne se trouvait préalablement sur ce premier noeud principal, et de manière à ce que des porteurs de charge se trouvant sur le deuxième noeud principal du premier bras de circuit circulent vers la jonction à effet tunnel du premier transistor à électron unique du premier bras de circuit, dans la mesure où un porteur de charge se trouve sur le premier noeud principal du premier bras de circuit,

- avec lequel au cours d'une deuxième étape, les valeurs pour le premier niveau de tension, le deuxième niveau de tension, le troisième niveau de tension et le quatrième niveau de tension sont réglées de manière à ce que des porteurs de charge se trouvant sur la jonction à effet tunnel du premier transistor à électron unique du premier bras de circuit circulent vers le deuxième noeud principal du premier bras de circuit,

- avec lequel au cours d'une troisième étape, les valeurs pour le premier niveau de tension, le deuxième niveau de tension, le troisième niveau de tension et le quatrième niveau de tension sont réglées de manière à ce que des porteurs de charge se trouvant sur le premier noeud principal du premier bras de circuit circulent via le deuxième transistor à électron unique vers la deuxième borne de tension de service, dans la mesure où un porteur de charge se trouve sur le deuxième noeud principal du premier bras de circuit,

- avec lequel au cours d'un deuxième déroulement, on applique le troisième niveau de tension à la première borne de tension de service du premier bras de circuit, le quatrième niveau de tension à la borne de gâchette du premier bras de circuit, le premier niveau de tension à la première borne de tension de service du deuxième bras de circuit, et le deuxième niveau de tension à la borne de gâchette du deuxième bras de circuit,

- avec lequel au cours d'une première étape, les valeurs pour le premier niveau de tension, le deuxième niveau de tension, le troisième niveau de tension et le quatrième niveau de tension sont ajustées aux valeurs utilisées lors de la première étape du premier déroulement,

- avec lequel au cours d'une deuxième étape, les valeurs pour le premier niveau de tension, le deuxième niveau de tension, le troisième niveau de tension et le quatrième niveau de tension sont ajustées aux valeurs utilisées lors de la deuxième étape du premier déroulement,

- avec lequel au cours d'une troisième étape, les valeurs pour le premier niveau de tension, le deuxième niveau de tension, le troisième niveau de tension et le quatrième niveau de tension sont ajustées aux valeurs utilisées lors de la troisième étape du premier déroulement.

10. Procédé selon la revendication 9,
avec lequel le premier déroulement et le deuxième déroulement sont utilisés en alternance.

11. Utilisation du procédé selon les revendications 9 ou 10 pour l'addition de nombres binaires.

# FIG 1

FIG 2A

**FIG 2B**

SB1, SZ11, SZ12, SB2, SZ21, SZ22

ET111, K11, G1, T1, TK1, H112, H111, TK21, G2, T2, TK22, ET112

ET121, K12, G1, T1, TK1, H122, H121, TK21, G2, T2, TK22, ET122

ET211, K21, G1, T1, TK1, H212, H211, TK21, G2, T2, TK22, ET212

ET221, K22, G1, T1, TK1, H222, H221, TK21, G2, T2, TK22, ET222

FIG 3A

EP 1 010 205 B1

# FIG 3B

EP 1 010 205 B1

# FIG 3C

EP 1 010 205 B1

FIG 3D

# FIG 3E

EP 1 010 205 B1

# FIG 3F

EP 1 010 205 B1

FIG 3G

EP 1 010 205 B1

# FIG 3H

EP 1 010 205 B1

FIG 3I

EP 1 010 205 B1

FIG 3J

30

# FIG 3K

# FIG 3L

EP 1 010 205 B1